# EUROPEAN PATENT SPECIFICATION

(11) **EP 1 599 943 B1**
(45) Date of publication and mention of the grant of the patent: **05.03.2008**
(21) Application number: 04703035.8
(22) Date of filing: 16.01.2004
(51) Int. Cl.: H03L 7/085

(54) **CLOCK AND DATA RECOVERY PHASE-LOCKED LOOP AND HIGH-SPEED PHASE DETECTOR ARCHITECTURE**
PHASENREGELKREIS ZUR DATEN- UND TAKTRÜCKGEWINNUNG UND HOCHGESCHWINDIGKEITSPHASENDETEKTORARCHITEKTUR
BOUCLE A VERROUILLAGE DE PHASE A RECUPERATION D'HORLOGE ET DE DONNEES ET ARCHITECTURE DE DETECTION DE PHASE A VITESSE ELEVEE

(30) Priority: 17.01.2003 US 346435; 22.04.2003 US 421247
(43) Date of publication of application: 30.11.2005
(73) Proprietor: Xilinx, Inc., San Jose, California 95124-3400 (US)
(72) Inventor: BRUNN, Brian, T., Austin, TX 78738 (US); AHMED, Younis, San Jose, CA 95124 (US); SHAHRIAR, Rokhsaz, Austin, TX 78731 (US)
(74) Representative: Naismith, Robert Stewart
(86) International application number: PCT/US2004/001212
(87) International publication number: WO 2004/066074

(56) References cited:
- US-A- 6 034 554
- US-A1- 2002 021 470
- US-A1- 2003 001 557
- US-B1- 6 356 160

## Description

### BACKGROUND OF THE INVENTION

### TECHNICAL FIELD OF THE INVENTION

This invention relates generally to communication systems and more particularly to clock recovery circuits and high-speed phase detector circuits used therein.

### DESCRIPTION OF RELATED ART

Communication systems are known to transport large amounts of data between a plurality of end user devices, which, for example, include telephones, facsimile machines, computers, television sets, cellular telephones, personal digital assistants, etc. As is also known, such communication systems may be local area networks (LANs) and/or wide area networks (WANs) that are stand-alone communication systems or interconnected to other LANs and/or WANs as part of a public switched telephone network (PSTN), packet switched data network (PSDN), integrated service digital network (ISDN), or Internet. As is further known, communication systems include a plurality of system equipment to facilitate the transporting of data. Such system equipment includes, but is not limited to, routers, switches, bridges, gateways, protocol converters, frame relays, private branch exchanges, etc.

The transportation of data within communication systems is governed by one or more standards that ensure the integrity of data conveyances and fairness of access for data conveyances. For example, there are a variety of Ethernet standards that govern serial transmissions within a communication system at data rates of 10 megabits per second, 100 megabits per second, 1 gigabit per second and beyond. Some synchronous Optical NETwork (SONET), for example, requires 10 gigabits per second. In accordance with such standards, many system components and end user devices of a communication system transport data via serial transmission paths. Internally, however, the system components and end user devices may process data in a parallel manner. As such, each system component and end user device must receive the serial data without loss of information, and convert the serial data into parallel data also without loss of information. Accurate recovery of information from high-speed serial transmissions typically requires transceiver components that operate at clock speeds equal to or higher than the received serial data rate. Higher clock speeds limit the usefulness of prior art clock recovery circuits that require precise alignment of signals to recover clock and/or data. Higher data rates require greater bandwidth for the feedback loop to operate correctly. Some prior art designs are bandwidth limited. One method used in prior art to overcome a precise alignment problem was to insert a one-half data bit delay between phase detector control signals. Generating a consistent one-half data bit delay in high-speed circuits over process, voltage, and temperature and in the presence of phase noise and clock skew is problematic.

As the demand for data throughput increases, so do the demands on a high-speed serial transceiver. The increased throughput demands are pushing some current integrated circuit manufacturing processes to their operating limits, where integrated circuit processing limits (e.g., device parasitics, trace sizes, propagation delays, device sizes, etc.) and integrated circuit (IC) fabrication limits (e.g., IC layout, frequency response of the packaging, frequency response of bonding wires, etc.) limit the speed at which the high-speed serial transceiver may operate without excessive jitter performance and/or noise performance. For example, phase and transition signals are required to be aligned under prior art designs to facilitate proper phase alignment. Jitter and other timing delays, however, adversely affect a system's ability to properly recover a clock in a received signal.

A further alternative for high-speed serial transceivers is to use an IC technology that inherently provides for greater speeds. For instance, switching from a complimentary metal oxide semi-conductor (CMOS) process to a silicon germanium or gallium arsenide process would allow integrated circuit transceivers to operate at greater speeds, but at substantially increased manufacturing costs. CMOS is more cost effective and provides easier system integration. Currently, for most commercial-grade applications, including communication systems, such alternate integrated circuit fabrication processes are too cost prohibitive for wide spread use.

What is needed, therefore, is an apparatus that can receive high-speed serial transmissions and provide the received serial data to parallel devices at data rates that ensure data integrity and can be obtained with cost-conscious technology, and an apparatus that can receive high-speed serial transmissions and recover the clock and/or data by providing a repeatable, fixed delay in phase detector control signals while ensuring data integrity with cost-conscious technology.

US6356160 describes a high-speed data communication system which includes a receiver to recover data and clock signals from communicated data. The receiver circuit has a dual phase lock loop (PLL) circuit, a fine loop of the PLL includes a phase detector providing a differential analog voltage output and a coarse loop of the PLL allows for fast frequency acquisition of an internal oscillator.

US6034554 describes an improved phase detector for detecting the difference between an information signal and a clock signal

US2002/021470 describes a method and apparatus for recovering a clock and data from a data signal. One method of the invention includes receiving the data signal having a first data rate, receiving the clock signal having a first clock frequency, alternating between a first level and a second level, wherein the first data rate is twice the first clock frequency.

### BRIEF SUMMARY OF THE INVENTION

A clock recovery circuit that operates at a clock speed equal to one-half the input data rate is presented to improve phase and transition alignment limitations. The clock recovery circuit uses dual input latches to sample incoming serial data on both the rising edge and falling edge of a half-rate feedback signal to provide equivalent full data rate clock and data recovery. The clock and data recovery circuit functions to maintain the half-rate feedback signal transitions in a desired timing relationship to the incoming serial data bits (e.g., substantially near the center of the incoming data). The clock and data recovery circuit includes a phase detector, a charge pump, a controlled oscillation module, and a feedback module. The phase detector produces information about the phase and transitions in an input data signal to the charge pump. The phase information indicates how well the feedback signal is aligned with the input data signal. The transition information indicates a change in logic levels between two successive data bits. The charge pump, which includes superposition circuitry and an output module, generates a first signal component when the phase information is in a first state, a second signal component when the phase information is in a second state, a third signal component when the transition information is in the first state, and a fourth signal component when the transition information is in the second state, wherein the first, second, third, and fourth signal components are current signals in one embodiment of the invention.

The output module, operably coupled to receive the first, second, third, and fourth signal components, generates an error signal from the first, second, third, and fourth current components.

An oscillation module is operably coupled to convert the error signal into an oscillating signal. The feedback module is operably coupled to generate the feedback signal based on the oscillating signal and a divider value.

The preferred embodiment of the invention uses a delay insensitive architecture that does not require phase and transition alignment thereby overcoming limitations of the prior art.

A high speed phase detector circuit operating at a clock speed equal to one-half an input data rate (i.e., a half-rate clock) is presented to provide phase information and transition information from incoming serial data. The high speed phase detector circuit uses a pair of latches, clocked on complimentary signals, to sample the incoming serial data on both the rising edge and falling edge of the half-rate clock to provide equivalent full high speed data rate sampling. The high speed phase detector circuit functions to maintain the half-rate clock signal transitions in a desired timing relationship to the incoming serial data (e.g., substantially near the center of the incoming data when the loop is locked). The high speed phase detector circuit produces the phase information and the transition information from combinational logic coupled to outputs of a second latch and a fourth latch. The phase information indicates how well the feedback signal is aligned with the incoming serial data and is used to adjust a phase of the half-rate clock to maintain the desired timing relationship. The transition information, indicating a change in logic levels between two successive incoming serial data bits, is used to maintain a phase lock when the incoming serial data contains a sequence of serial data bits with the same logic level.

The high speed phase detector circuit includes first and second configurations of combinational logic coupled across a second latch and fourth latch, clocked on complimentary signals, to generate a delay between the phase information and the transition information. In one described embodiment of the invention, the delay is equal to one-half bit period. In alternate embodiments of the invention, the delay may vary. For example, if master-slave configured flip flops are used in place of the second and fourth latches, the delay is approximately equal to one and one-half bit periods. Generally, therefore, the delay is a multiple of one-half bit period increments.

The phase information is produced in a first bit period and the transition information is produced in a second bit period relative to the first bit period, wherein the phase information is reliably timed for a middle of the first bit period and the transition information is reliably timed for a beginning of the second bit period. Accordingly, the phase and transition information are provided to an error signal generation module that, in turn, provides a corresponding error signal to a controlled oscillation module. The oscillation module then generates an oscillating signal that is produced to a feedback module, which, in turn, produces a feedback signal to the phase detector.

### BRIEF DESCRIPTION OF THE DRAWINGS

Figure 1 illustrates a block diagram of a clock recovery circuit in accordance with an embodiment of the present invention;
Figure 2 illustrates a schematic block diagram of a phase detector of the clock recovery circuit of Figure 1;
Figure 3 illustrates a timing diagram for the phase detector of Figure 2;
Figure 4 illustrates a schematic block diagram of a charge pump of the clock recovery circuit of Figure 1;
Figure 5 illustrates the superposition circuitry of the charge pump of Figure 4 generating a first signal component;
Figure 6 illustrates the superposition circuitry of the charge pump of Figure 4 generating a second signal component;
Figure 7 illustrates the superposition circuitry of the charge pump of Figure 4 generating a third signal component;
Figure 8 illustrates the superposition circuitry of the charge pump of Figure 4 generating a fourth signal component;
Figure 9 illustrates a schematic block diagram of a transceiver in accordance with the present invention;
Figure 10 illustrates a schematic block diagram of a receiver clock recovery module of the transceiver of Figure 9;
Figure 11 illustrates an alternate embodiment of the transceiver;
Figure 12 illustrates a block diagram of a phase locked loop circuit in accordance with the present invention;
Figure 13 illustrates a schematic block diagram of a phase detector of the phase locked loop circuit of Figure 12;
Figure 14 illustrates timing diagrams for the phase detector of Figure 13;
Figure 15 illustrates a schematic block diagram of an alternate embodiment of a phase detector of the phase locked loop circuit of Figure 12;
Figure 16 illustrates a schematic block diagram of a coarse frequency control module;
Figure 17 illustrates a block diagram of a clock recovery circuit in accordance with one embodiment of the present invention; and
Figures 18a and 18b illustrate a flow chart of a phase locked loop method according to the present invention.

### DETAILED DESCRIPTION OF THE INVENTION

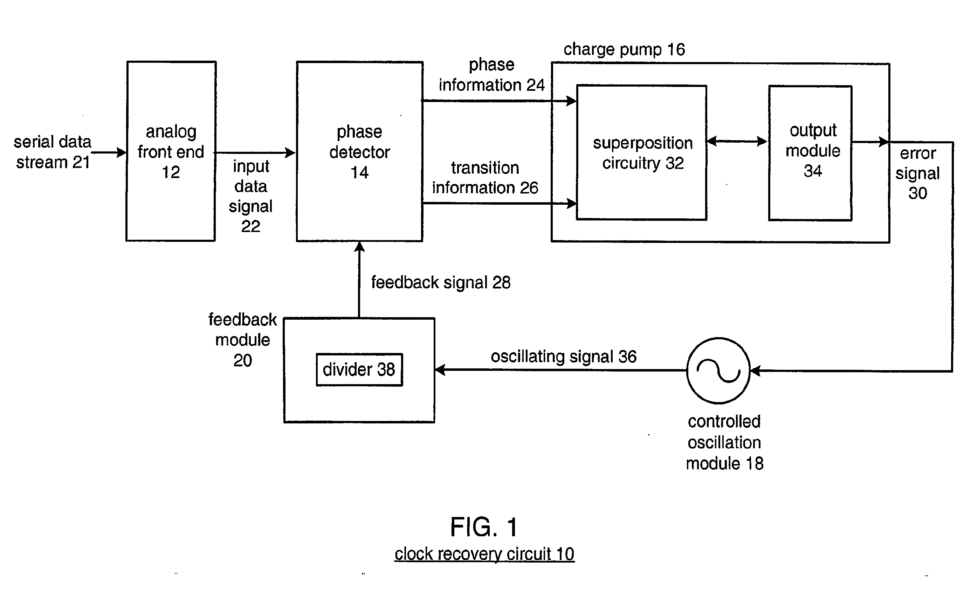

Figure 1 illustrates a block diagram of a clock and/or data recovery circuit 10 in accordance with the preferred embodiment of the present invention. The clock recovery circuit 10 includes an analog front end 12, a phase detector 14, a charge pump 16, a controlled oscillation module 18, and a feedback module 20. Charge pump 16 includes superposition circuitry 32 and an output module 34.

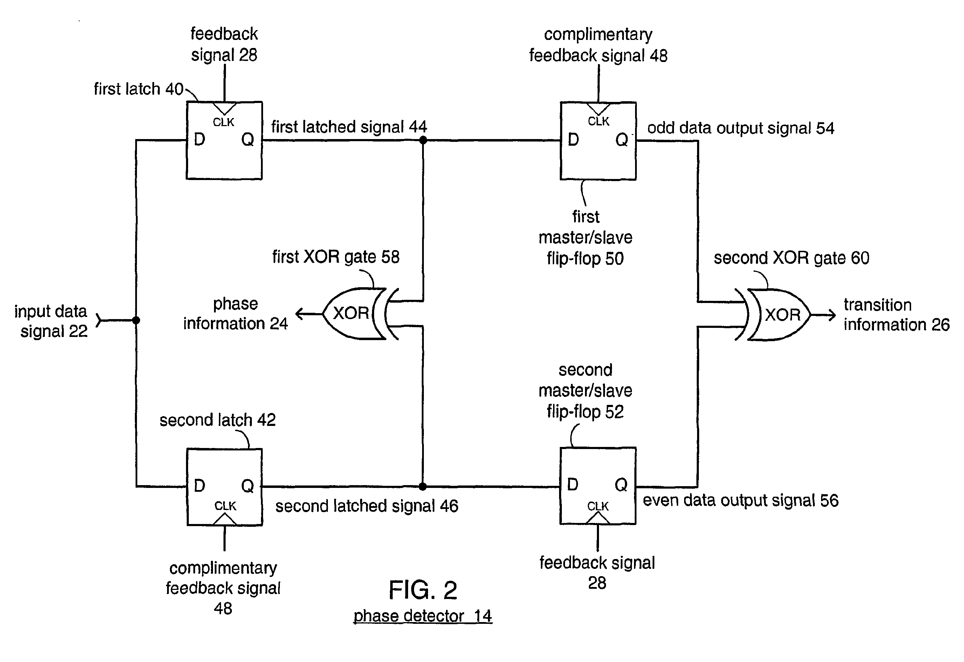

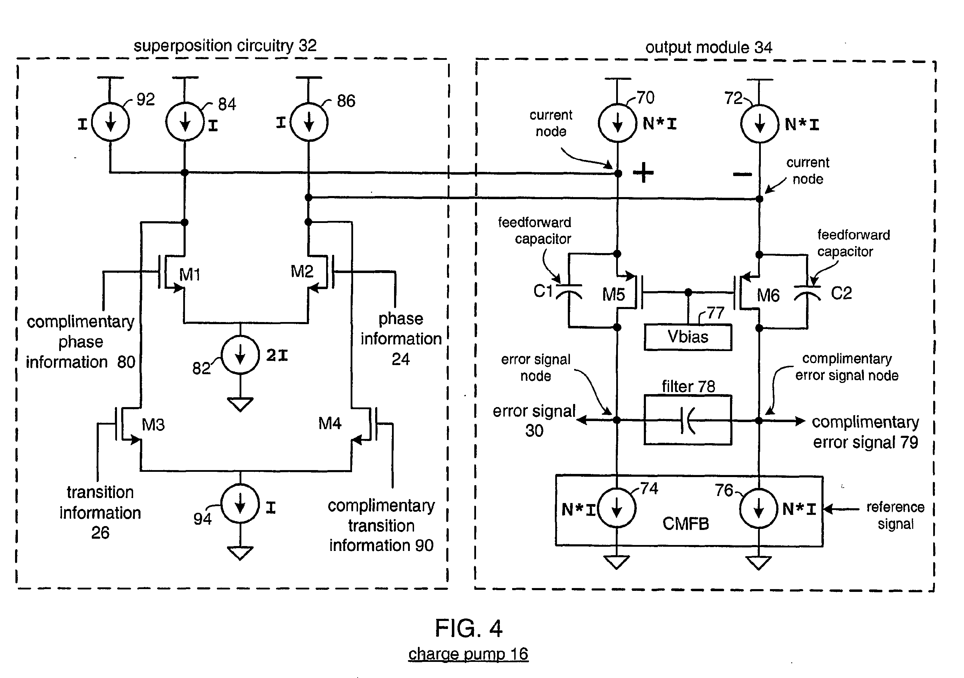

Analog front end 12 receives a serial data stream 21, which may be a high data rate bit stream transferring data at 10 or more gigabits per second. This high data rate usually results in some loss of high frequency components of the bit stream due to the limited bandwidth of the input line. Analog front end 12 provides amplitude equalization to produce input data signal 22. Phase detector 14 produces phase information 24 and transition information 26 based on the input data signal 22 and a feedback signal 28. Operation of phase detector 14 will be discussed in greater detail with reference to Figure 2. Charge pump 16 produces an error signal 30 based on the phase information 24 and transition information 26. Operation of charge pump 16 will be discussed in greater detail with reference to Figure 4. The controlled oscillation module 18 receives the error signal 30 and produces therefrom an oscillating signal, which represents the recovered clock signal. Feedback module 20 and divider 38 generate feedback signal 28 by dividing oscillating signal 36 by a divider value, which may be a whole number equal to or greater than one. Feedback module 20 and divider 38 adjust feedback signal 28 to one-half the data rate of the input data signal.

Figure 2 illustrates a schematic block diagram of a phase detector 14 of the clock recovery circuit of Figure 1. Phase detector 14 functions to produce phase information 24 and transition information 26 based on the relationship between input data signal 22 and feedback signal 28. Generally, phase information 24 reflects a phase relationship of an input signal with respect to the feedback signal while transition information 26 reflects that there has been a logic state change between two successive data bits of the input data. More specifically, phase information 24 is representative of the relative phase difference between input data signal 22 and feedback signal 28. As described previously, the feedback signal is adjusted to one-half the data rate of the input data signal or to another desired fractional rate of the data based on the data recovery scheme.

With the high data rates prevalent in data communications, (e.g., SONET), designing a 10 or greater gigabit per second oscillator is difficult. By using a one-half data rate design and sampling on both the rising and falling edges of the feedback signal, an effective 10 gigabit per second rate is achieved. The data contained in input data signal 22 is essentially random, thus it is just as probable to receive a consecutive series of logic ones or logic zeros as it is to receive an alternating pattern of logic ones and logic zeros. Phase detector 14 produces transition information 26 to indicate a change in logic levels of input data signal 22. Transition information 26 will remain at logic one as long as the input data signal 22 changes states at least once every one-half clock cycle, or 100 pico-seconds for the 5 GHz feedback signal of the present design in a locked condition where data and clock are 90 degrees out of phase, i.e. sampling in middle the data. The transition information will change to a logic zero when the input data signal logic level remains constant, indicating same level consecutive data bits. When there is not a transition on the data, charge pump 16 uses the transition information to prevent controlled oscillation module 18 from erroneously changing frequency on an average.

Continuing with the description of Figure 2, the input data signal 22 is coupled to a first latch 40 and a second latch 42 to produce a first latched signal 44 and a second latched signal 46, respectively. As is known by one of average skill in the art, latches couple data on an input terminal D to an output terminal Q as long as a CLK terminal on the latch is at logic one and samples the data on the falling edge of the clock (or vice versa). First latch 40 receives feedback signal 28 at the CLK terminal, while second latch 42 receives a complimentary feedback signal 48 at the CLK terminal. Thus, one latch triggers on a rising edge of the feedback signal while the other effectively triggers on a falling edge of the feedback signal.

The first latched signal 44 and second latched signal 46 are further coupled to first exclusive OR (XOR) gate 58 to produce phase information 24. Due to the quadrature sampling of feedback signals (feedback signal 28 and complimentary feedback signal 48) and the first XOR gate 58, phase information 24 will be proportional to the phase difference between input data signal 22 and feedback signal 28. The output thus reflects how far the transition edge of feedback signal 28 (or complimentary feedback signal 48) is from the center of a data bit. The pulse width of phase information 24, when there is a transition in the input data, will be one-half bit period when the feedback signal is centered on the data bit.

First latched signal 44 and second latched signal 46 are coupled to a first master/slave flip-flop 50 and a second master/slave flip-flop 52, respectively. Operation of a master/slave flip-flop differs from operation of a latch in that data on the input terminal D will be sampled during the transition of the CLK signal then the sampled data is coupled to the output terminal Q during the next alternate transition of the CLK signal. Operation of the latch followed by the master/slave flip-flop clocked by complimentary clock signals (feedback signal 28 and complimentary feedback signal 48) serves to produce an output signal composed of alternate bits in the input data signal (half of the full rate). First master/slave flip-flop 50 will produce an odd data output signal 54 while second mater/slave flip-flop 52 will produce an even data output signal 56. One of average skill in the art will recognize that the choice of even and odd is simply a method to describe the contents of the data signal from an arbitrary point in time and should not be construed to mean the actual logic state of the data.

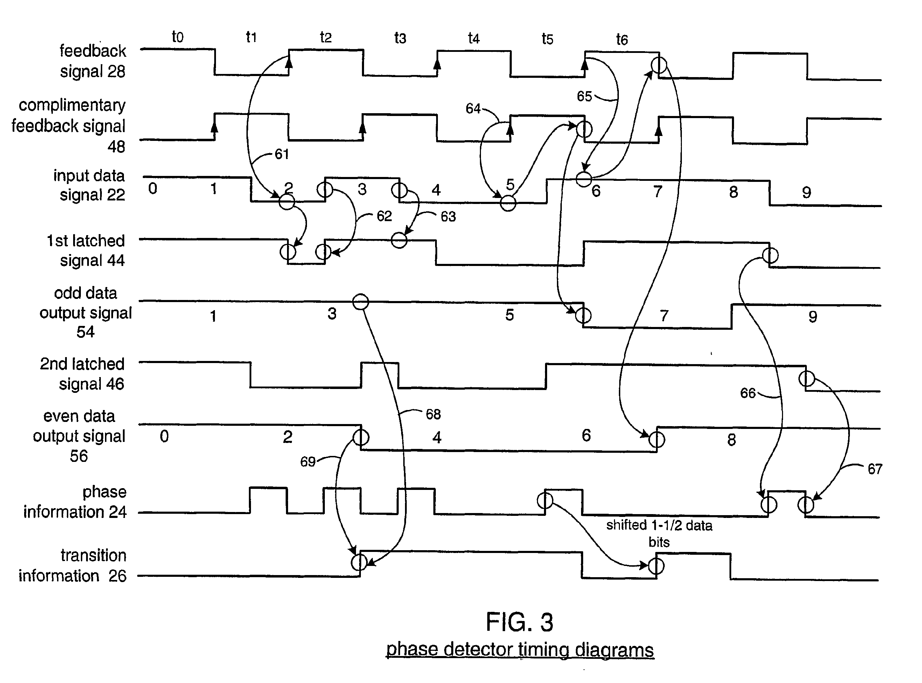

The odd data output signal 54 and even data output signal 56 are coupled to second XOR gate 60 to produce transition information 26. The transition information is indicative of a change in input data signal 22 logic levels. The phase and transition information, as described herein, will be discussed in more detail with respect to Figure 3.

Figure 3 illustrates timing diagrams for the phase detector of Figure 2. The timing diagrams shown are for single-ended devices to simplify discussion, though one of average skill in the art should recognize that either single-ended or differential signaling may be used. Additionally, the timing diagrams illustrate "perfect" signals with zero rise time, zero fall time, zero propagation delay and no overshoot or undershoot for exemplary purposes. Additionally, small arrows indicate the sampling edge of feedback signal 28 and complimentary feedback signal 48.

Input data signal 22 comprises a random data bit pattern. The data bits are numbered zero through nine for the purposes of discussion and not intended to convey any information regarding the data. Furthermore, the timing diagrams illustrate phase detector 14 locked to input data signal 22 with feedback signal 28 and complimentary feedback signal 48 transitioning in the center of each data bit. First latched signal 44 follows input data signal 22 during the logic one periods of feedback signal 28, time periods t0, t2, t4, etc. Thus, if input data signal 22 transitions from one level to another, such as the transition during time period t2, first latched signal 44 will follow it as long as feedback signal 28 is logic one. For example, at the rising edge of feedback signal 28 at the start of time period t2, first latched signal 44 transitions to logic zero since input data signal 22 is logic zero. Timing line 61 indicates this sequence. When input data signal 22 transitions to logic one, first latched signal 44 also transitions to logic one as indicated by timing line 62. First latched signal 44 holds the logic one level once feedback signal 28 transitions to logic zero at the end of time period t2. As shown by timing line 63, first latched signal 44 holds the logic one level when input data signal 22 transitions to logic zero. Similarly, second latched signal 46 follows input data signal 22 during logic one periods of complimentary feedback signal 48.

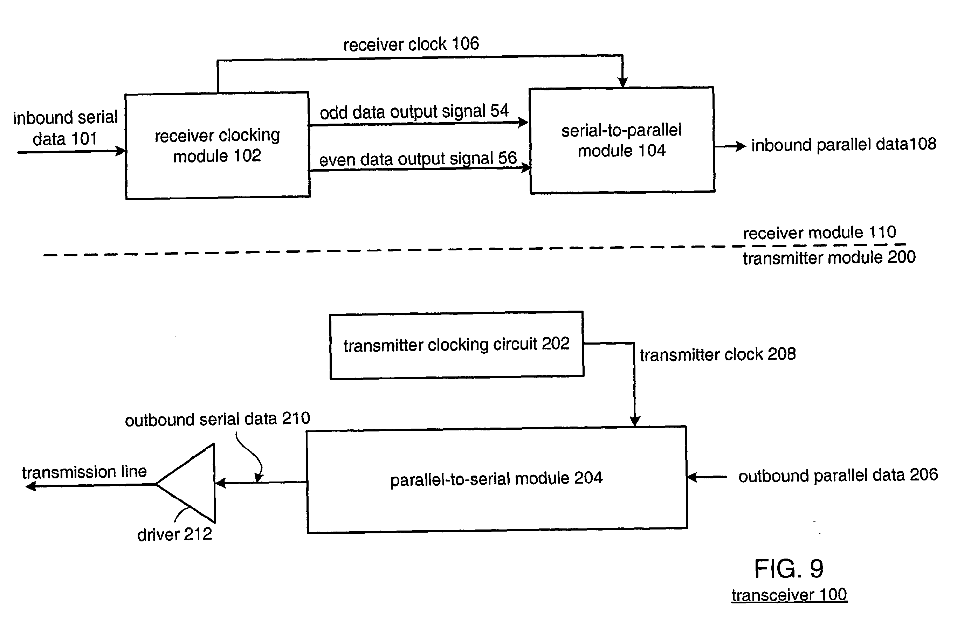

Odd data output signal 54 and even data output signal 56 are produced from first latched signal 44 and second latched signal 46, respectively. First master/slave flip-flop 50 samples first latched signal 44 at terminal D during the transition of complimentary feedback signal 48. The sampled signal is coupled to the output terminal Q during the next transition of complimentary feedback signal 48. Timing line 64 illustrates odd data output signal 54 transitioning to a logic zero as the sampled signal is coupled to the output terminal Q. In a similar manner, second master/slave flip-flop 52 produces even data output signal 56 during alternate transitions of feedback signal 28, as shown by timing line 65. As further shown in Figure 3, odd data output signal 54 contains data consistent with the odd numbered data bits of input data signal 22, while even data output signal 56 contains data consistent with even number data bits of input data signal 22. The even and odd data output signals can be combined in a serial-to-parallel converter to reconstruct the original data. The operation of the serial-to-parallel converter will be discussed with reference to Figure 9.

Phase information 24 is produced from first latched signal 44 and second latched signal 46 by first exclusive OR (XOR) gate 58, as shown by timing lines 66 and 67. The width of the pulses will be proportional to the phase difference between the transition of input data signal 22 and the transition of feedback signal 28. The phase detector will adjust the phase of feedback signal 28 to maintain the transitions in the center of input data signal 22, thus, when phase locked, each phase information logic one pulse will be equal to one-half bit period.

Transition information 26 is produced from odd data output signal 54 and even data output signal 56 by second XOR gate 60, as shown by timing lines 68 and 69. Transition information 26 will remain at logic one as long as a data transition is detected once each bit period. Each transition information 26 logic transition is an integer multiple of one bit period and, due to the XOR gate function, will be shifted from phase information 24 pulses by one and one-half bit periods (150 picoseconds at 10 gigabits per second) when phase locked. In an alternate embodiment using latches in place of first master-slave flip-flop 50 and second master-slave flip-flop 52, the transition information is shifted, relative to the phase information, by one-half bit period (50 picoseconds at 10 gigabits per second). The delay insensitive architecture of the preferred embodiment of the present invention does not require phase and transition alignment and can tolerate the timing shift between the phase and transition information.

Figure 4 illustrates a schematic block diagram of charge pump 16 of the clock recovery circuit of Figure 1. Charge pump 16 comprises superposition circuitry 32 and output module 34 coupled to receive phase information 24 and transition information 26 from a phase detector and to generate error signal 30 to an external oscillator module or other device. Superposition circuitry 32 is formed to sink and source current to output module 34 based on the logic levels of phase information 24 and transition information 26.

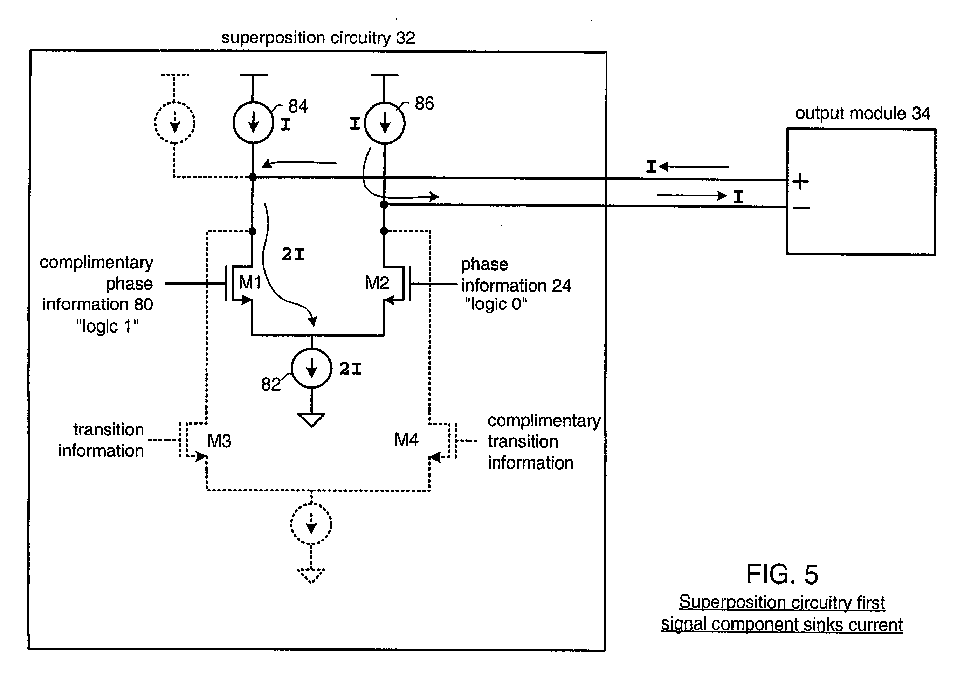

As shown in Figure 4, superposition circuitry 32 includes current sources 84 and 92 coupled to output module 34 and to the drain terminals of MOS transistors M1 and M3. Superposition circuitry 32 further includes current source 86 coupled to output module 34 and to the drain terminals of MOS transistors M2 and M4. MOS transistors M1 and M2 have source terminals coupled to current sink 82. The source terminals of MOS transistors M3 and M4 are coupled to current sink 94. The gate terminal of MOS transistor M2 is coupled to receive the phase information 24, while the gate terminal of MOS transistor M1 is coupled to receive the complimentary phase information 80. The gate terminal of MOS transistor M4 is coupled to receive complimentary transition information 90, while the gate terminal of MOS transistor M3 is coupled to receive the transition information 26. As configured, MOS transistors M1-M4 of superposition circuitry 32 will steer current into or out of output module 34 responsive to the phase and transition information. The operation of superposition circuitry will be more fully explained with reference to Figures 5-8.

Output module 34 receives and converts superposition circuitry 32 current components into error signal 30 and complimentary error signal 79. A plurality of current sources, namely current sources 70-76 of output module 34, conducts current through bias MOS transistors M5 and M6 to shift the common mode of error signal 30 and complimentary error signal 79 using a reference signal. In general, current sources 70-76 conduct "N" (a whole number) times more current than the "I" current sources of superposition circuitry 32. In the present embodiment, "N" is equal to five.

Current source 70 is connected to the source terminal of bias MOS transistor M5 and to a first terminal of feedforward capacitor C1. The drain terminal of bias MOS transistor M5 and a second terminal of feedforward capacitor C1 are coupled to the error signal node of filter 78 and to current source 74. Similarly, current source 72 is connected to the source terminal of bias MOS transistor M6 and to feedforward capacitor C2. The drain terminal of bias MOS transistor M6 and a second terminal of feedforward capacitor C2 are coupled to the complimentary error signal node of filter 78 and to current source 76. The gate terminals of bias MOS transistors M5 and M6 are coupled to biasing circuitry Vbias 77. Feedforward capacitors C1 and C2, coupled from the source terminals to drain terminals of bias MOS transistors M5 and M6, provide a low impedance path that bypasses most of the high frequency current around bias MOS transistors M5 and M6.

The transfer function zero created by feedforward capacitors C1 and C2 tends to cancel a pole at the positive and negative current nodes. By adding the feedforward capacitors to provide an alternate path for high frequency current components, the charge pump output current is independent of the input data pattern, thus overcoming a problem with the prior art. Filter 78 provides a transimpedance function by charging and discharging in response to the current components of superposition circuitry 32.

The voltage developed across filter 78 is provided as error signal 30 and as complimentary error signal 79 to controlled oscillation module 18 (not shown in Figure 4). The oscillating frequency of controlled oscillation module 18 will change in response to a change in the error signal voltage thereby changing feedback signal 28 (not shown in Figure 4) which, in turn, adjusts the phase information produced by phase detector 14 (not shown in Figure 4). The operation of phase detector 14 was discussed with reference to Figure 2.

Figure 5 illustrates the superposition circuitry of the charge pump of Figure 4 generating a first signal component. As is known by one of average skill in the art, the superposition theorem says that the effects of independent sources in a linear network can be calculated by adding the contribution of each independent source acting alone. The effects of the phase information and transition information on superposition circuitry 32 can be evaluated separately with filter 78 of output module 34 functioning as a summing junction. Continuing with the discussion of Figure 5, the first signal component is generated when phase information 24 is logic zero and complimentary phase information 80 is logic one. In this mode, the transition circuitry is inactive and shown as dashed lines in Figure 5. Since phase information 24 is logic zero, MOS transistor M2 is not conducting. MOS transistor M1, by virtue of complimentary phase information 80 being logic one, is conducting a current of 2I to current source (sink) 82. Current source 84 conducts I current so output module 34 must supply the additional I current. In other words, superposition circuitry 32 sinks current from output module 34. Current source 86 conducts current into the negative terminal since this is a differential circuit, though one of average skill in the art should realize the superposition circuitry may be implemented as a single-ended circuit.

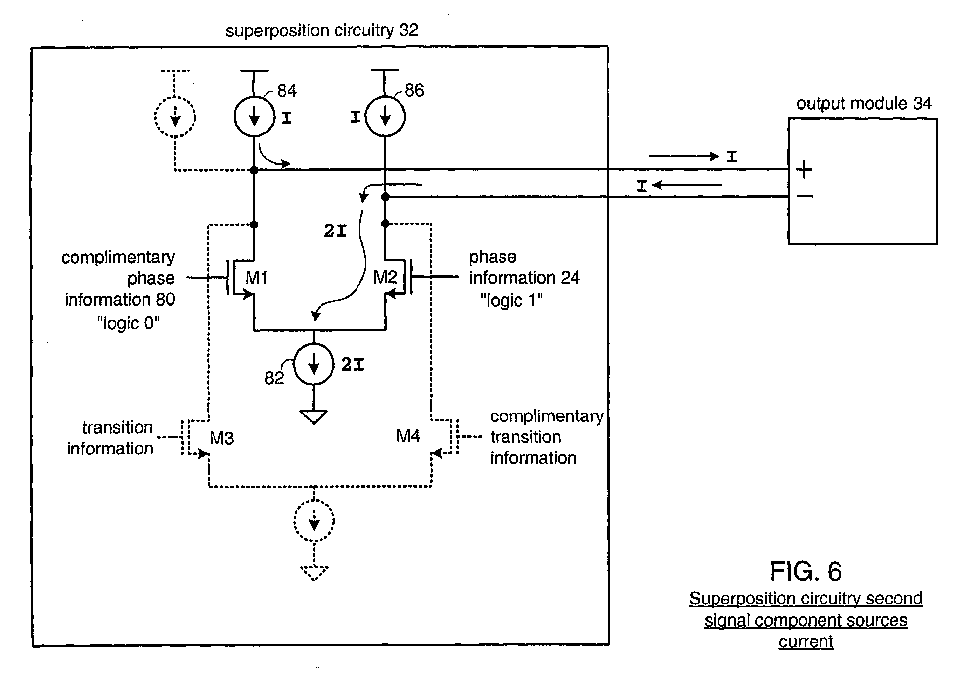

Figure 6 illustrates the superposition circuitry of the charge pump of Figure 4 generating a second signal component. Phase information 24 is logic one so complimentary phase information 80 is logic zero. MOS transistor M1 is turned off due to the logic zero coupled to its gate terminal. Current conducted by current source 84 is sourced to output module 34. MOS transistor M2 conducts 2I current due to the logic one applied to its gate terminal. Because current source 86 only supplies I current, the negative terminal of output module 34 supplies I current consistent with the differential operation of this circuit to balance the 2I current generated by current source (sink) 82. In other words, superposition circuitry 32 sources current to output module 34.

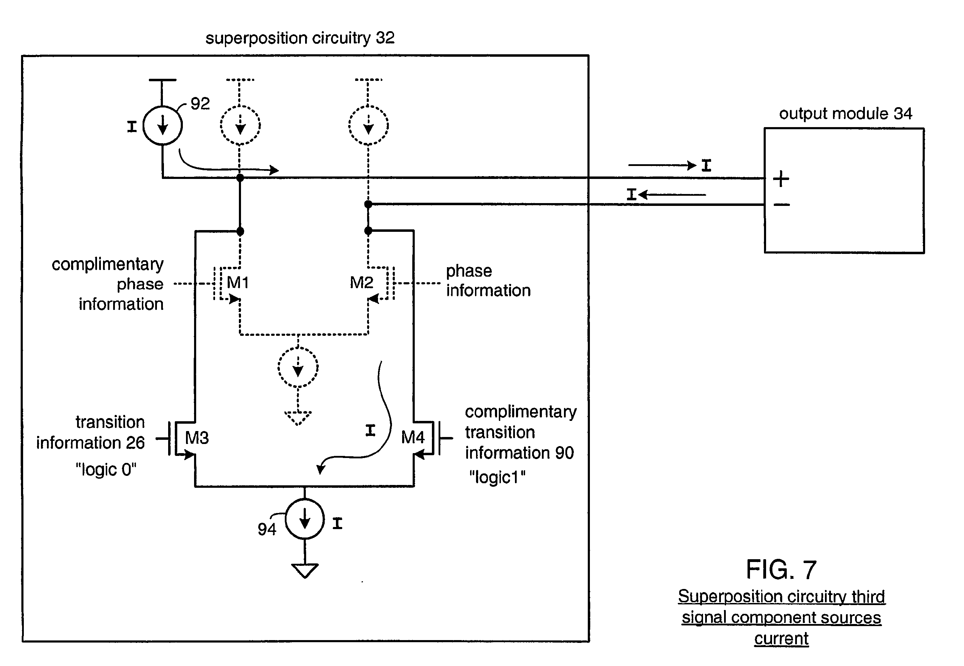

Figure 7 illustrates the superposition circuitry of the charge pump of Figure 4 generating a third signal component. In this mode of operation, the transition circuitry is active while the phase circuitry is inactive and therefore shown as dashed lines. Transition information 26 is logic zero while complimentary transition information 90 is logic one. When transition information 26 is logic zero, MOS transistor M3 is off. Current source 92 sources I current to output module 34. MOS transistor M4, turned on by logic one of complimentary transition information 90 coupled to the gate, conducts current I from output module 34 negative terminal to current source 94 coupled to the source terminal. In other words, superposition circuitry 32 sources current to output module 34.

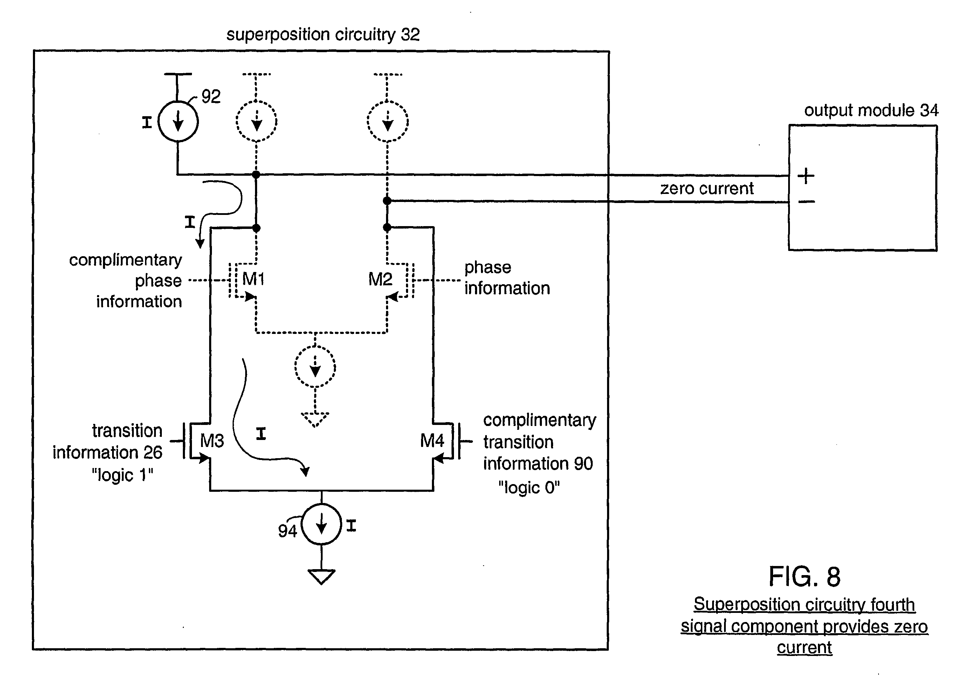

Figure 8 illustrates the superposition circuitry of the charge pump of Figure 4 generating a fourth signal component. Transition information 26 is at logic, one turning on MOS transistor M3, while complimentary transition information 90 is at logic zero turning off MOS transistor M4. MOS transistor M3 conducts I current supplied by current source 92 so the superposition circuitry provides zero current to output module 34.

In operation, the individual outputs of superposition circuitry 32 combine to produce sinking and sourcing currents to output module 34 responsive to the logic levels of both phase information 24 and transition information 26. Specifically, when transition information 26 is logic one, superposition circuitry 32 will sink "I" current when phase information is logic zero and source "I" current when phase information 24 is logic one. Sinking "I" current from output module 34 removes charge current from filter 78 thereby lowering the voltage developed across filter 78. Conversely, sourcing "I" current to output module 34 increases the voltage developed across filter 78. When transition information 26 is logic zero, superposition circuitry 32 will source "2I" current when phase information 24 is logic one and will provide zero current when phase information 24 is logic zero. The "2I" source current will double the voltage developed across filter 78 as compared to the "I" source current. While it appears that phase information 24 has twice the effect of transition information 26 ("2I" vs. "I"), the pulse width of phase information 24 is, when phase locked, one-half the pulse width of transition information 26, so transition information 26 charges filter 78 for a longer period of time thus producing an equivalent voltage. Because phase information 24 and transition information 26 are not necessarily aligned, superposition circuitry 32 may over charge filter 78 during one period and may under charge during another period. Overtime, however, the average charge will be zero when phase locked. This non-instantaneous response approach allows the inventive circuitry to be delay insensitive. As one of average skill in the art can appreciate, the superposition circuitry 32 may sink or source too much current during one period and may sink or source too little during another period. Over time, however, the average current produced by the superposition circuitry 32 will be zero when phase locked. The inventive superposition circuitry 32 works in conjunction with the inventive phase detector to provide signal delay insensitive operation. As is described herein, the phase and transition signals are not necessarily generated simultaneously by design (50 and 150 picosecond offsets according to described embodiment). The superposition circuitry, by nature of its design, is able to sink or source current independently (i.e., respond to phase and transition signaling independently) to provide frequency and phase error correction. Thus, the preferred embodiment avoids erroneous frequency and phase compensation on average instead of attempting to provide instantaneous frequency and phase error correction thus rendering the overall circuit delay insensitive and overcoming obstacles found in the prior art (No alignment of the phase and transition signal, or post processing of the error signal is required).

Figure 9 illustrates a schematic block diagram of a transceiver 100 that includes a receiver module 110 and transmitter module 200. Receiver module 110 includes a receiver clocking module 102 and a serial-to-parallel module 104. Transmitter module 200 includes a transmitter clocking circuit 202, a parallel-to-serial module 204, and a driver 212.

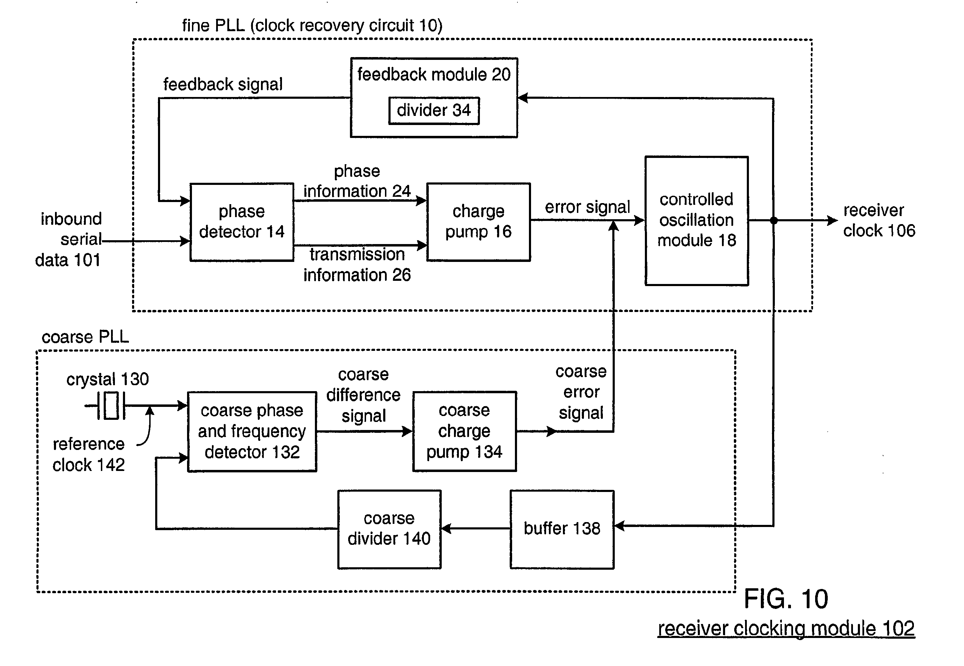

In operation, the receiver module 110 is operably coupled to receive an inbound serial data 101 via the receiver clocking module 102. The receiver clocking module 102, which will be discussed with reference to Figure 10, generates at least one receiver clock 106. Serial-to-parallel module 104 receives an odd data output signal 54, comprising serial odd data, and an even data output signal 56, comprising serial even data, from receiver clocking module 102 and converts the received serial data into inbound parallel data 108 based on the at least one receiver clock 106. The inbound parallel data 108 is clocked out of serial-to-parallel module 104 at a parallel data rate significantly slower than the at least one receiver clock 106. Accordingly, serial-to-parallel module 104 will divide the at least one receiver clock 106 into a plurality of lower data rate clocks to meet the required parallel data rate. Due to the difference in the serial data rate and the parallel data rate, serial-to-parallel module 104 typically stores the incoming serial data in an internal buffer or similar memory device prior to conversion. As one of average skill in the art will appreciate, the serial input and parallel output may be single-ended or differential signals.

Parallel-to-serial module 204 is operably coupled to receive outbound parallel data 206 and, based on at least one transmitter clock 208, produces outbound serial data 210. Driver 212 contains circuitry to drive a transmission line as well as providing isolation between the parallel-to-serial module 204 and the transmission line. As one of average skill in the art will appreciate, the parallel input and serial output may be single-ended or differential signals. As one of average skill in the art will further appreciate, transmitter clocking circuit 202 may be comprised of clock recovery circuit 10 to generate the transmitter clock 208.

Figure 10 illustrates a schematic block diagram of receiver clocking module 102 of the transceiver of Figure 9. The receiver clocking module 102 includes two phase locked loops (PLLs): a coarse PLL and a fine PLL comprising clock recovery module 10. In general, the coarse PLL establishes the desired frequency for the clocking circuit and the fine PLL adjusts the phase of the clock and it will also adjust a limited frequency offset to align it with the incoming data. In the present embodiment of the invention, the feedback signal frequency is one-half the frequency of the incoming data. The coarse PLL includes a crystal 130, a coarse phase and frequency detector 132, a coarse charge pump 134, a buffer 138, and a coarse divider 140. The fine PLL, comprising clock recovery module 10 was described with reference to Figure 1.

To establish the operating frequency for the clocking circuit, crystal 130 produces a reference clock 142 that is provided to the coarse phase and frequency detector 132. The coarse phase and frequency detector 132 determines the phase and frequency difference between the reference clock 142 and a divided representation of receiver clock 106. The coarse divider 140 provides the divided representation of the receiver clock 106 to the coarse phase and frequency detector 132. Based on the phase and frequency relationship of these signals, coarse phase and frequency detector 132 produces a coarse difference signal. Coarse charge pump 134 receives the coarse difference signal and produces a current representation (which is converted to voltage through the Transimpedance included at the output of the Fine Loop CP) thereof and provides a coarse error signal to controlled oscillation module 18. Controlled oscillation module 18 receives the coarse error signal and, adjusts the oscillation frequency of receiver clock 106. Once the coarse PLL has established the operating frequency, the fine PLL becomes active and adjusts the phase of the receiver clock.

Controlled oscillation module 18 may utilize inductor-capacitor oscillators to produce an output oscillation. By utilizing inductor-capacitor oscillators in comparison to ring oscillators, the noise levels of controlled oscillation module 18 are reduced.

As illustrated, receiver clocking module 102 includes two phase locked loops, one is a fine phase locked loop based on the data and the other is a coarse phase locked loop based on reference clock 142. Such sequential phased locked loop enables the receiver section to readily capture the inbound serial data. As one of average skill in the art will appreciate, receiver clocking module 102 may use single-ended signals or differential signals.

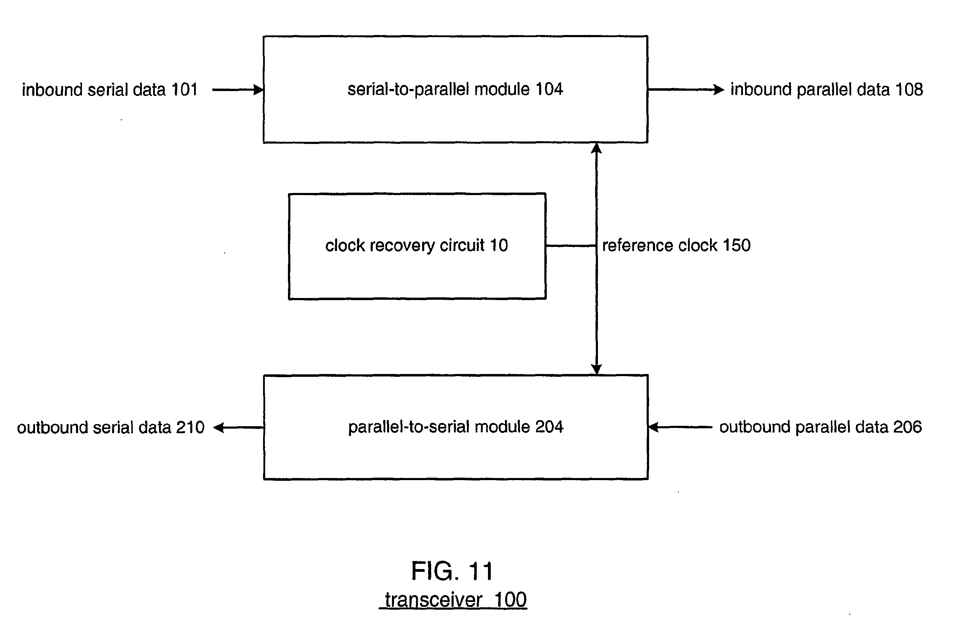

Figure 11 illustrates an alternate embodiment of transceiver 100 that includes serial-to-parallel module 104, parallel-to-serial module 204, and clock recovery circuit 10. In operation, the clock recovery circuit 10 may be implemented as the transmitter clocking circuit 202 illustrated in Figure 9 or, a portion thereof, and/or a combination thereof to produce at least one reference clock 150. The at least one reference clock 150 is provided to both the serial-to-parallel module 104 and the parallel-to-serial module 204.

The serial-to-parallel module 104 receives inbound serial data 101 and produces inbound parallel data 108 therefrom. The parallel-to-serial module 204 receives outbound parallel data 206 and produces outbound serial data 210 therefrom.

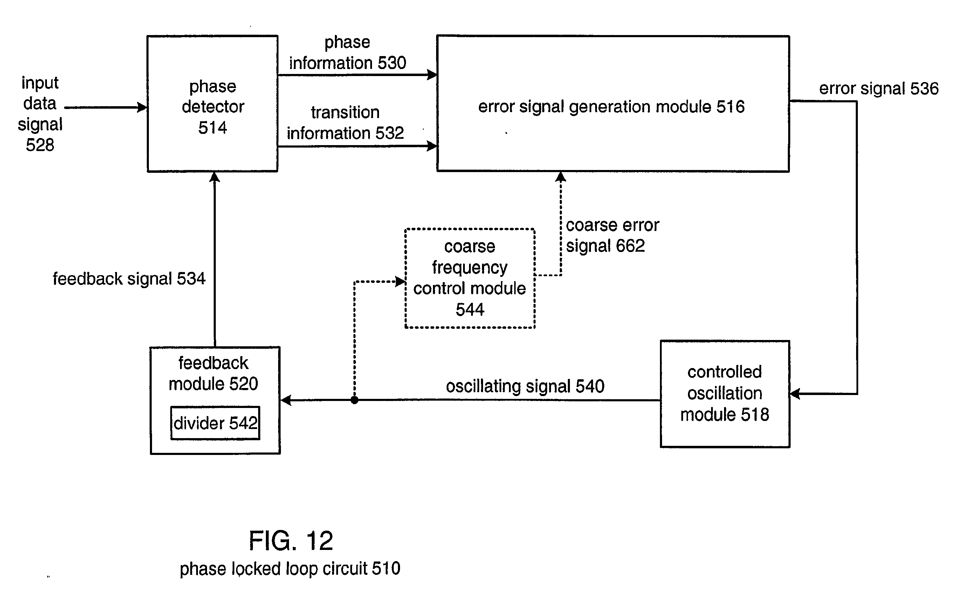

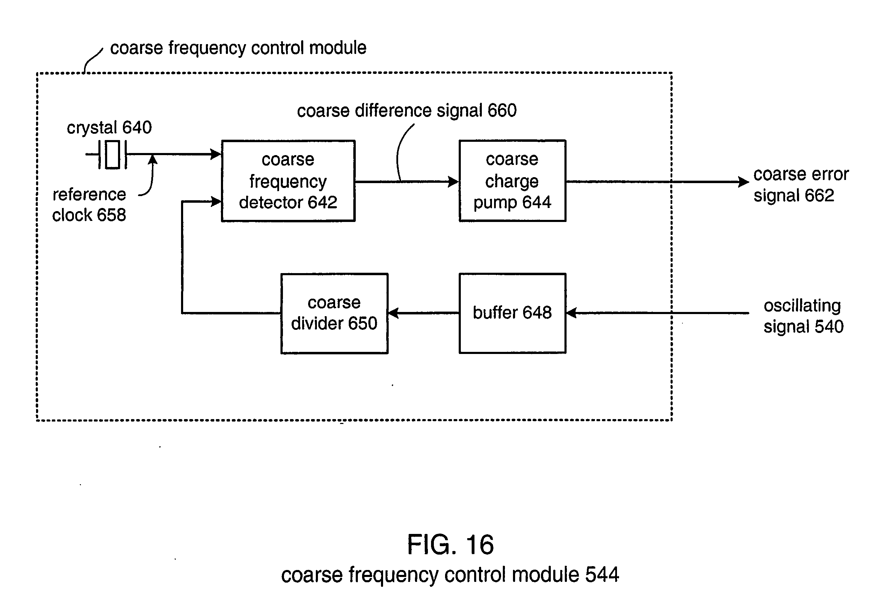

Figure 12 illustrates a block diagram of a phase locked loop circuit 510 in accordance with the present invention. The phase locked loop circuit 510 includes a phase detector 514, an error signal generation module 516, a controlled oscillation module 518, and a feedback module 520. Phase locked loop circuit 510 may include a coarse frequency control module 544 (illustrated in dashed lines) coupled to quickly establish a desired frequency for controlled oscillation module 518. The operation of coarse frequency control module 544 will be discussed with reference to Figure 16.

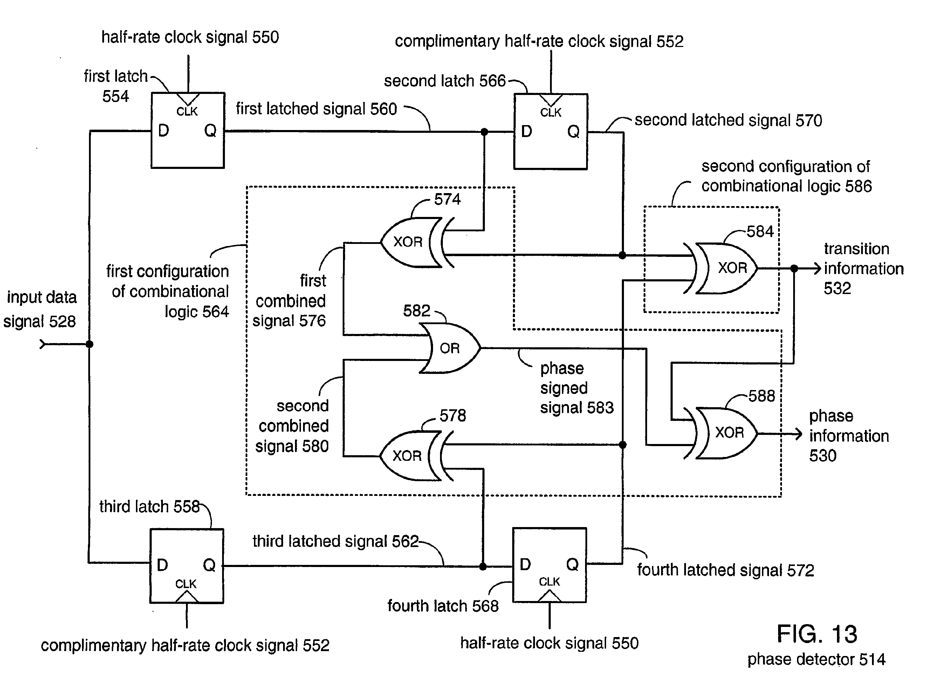

Phase detector 514 receives input data signal 528, which may be a high data rate bit stream (for example, 10 gigabits per second). Phase detector 514 produces phase information 530 and transition information 532 based on input data signal 528 and a feedback signal 534. Operation of phase detector 514 will be discussed in greater detail with reference to Figure 13. Error signal generation module 516 produces an error signal 536 based on phase information 530, transition information 532, and a coarse error signal 662 for phase locked loop circuits containing the coarse frequency control module.

Controlled oscillation module 518 receives error signal 536 and produces there from an oscillating signal 540, which represents a recovered clock signal. Controlled oscillation module 518 may utilize inductor-capacitor oscillators to produce an output oscillation based on a D.C. signal level (in one embodiment of the invention). By utilizing inductor-capacitor oscillators in comparison to ring oscillators, the noise levels of controlled oscillation module 518 are reduced. Feedback module 520 and a divider 542 generate feedback signal 534 by dividing oscillating signal 540 by a divider value, which may be a whole number equal to or greater than one. The divider value is selected so that feedback module 520 and divider 542 adjust feedback signal 534 to one-half the data rate of input data signal 528. The error signal module comprises, in one embodiment, a charge pump and/or a transconductance circuit such as, for example, previously disclosed herein.

Figure 13 illustrates a schematic block diagram of a phase detector 514 of the phase locked loop circuit of Figure 12. Feedback signal 534 of Figure 12 is produced to each latch as half-rate clock signal 550 or as complimentary half-rate clock signal 552 by techniques known to those with average skill in the art. Phase detector 514 functions to produce phase information 530 and transition information 532 based on the relationship between input data signal 528 and half-rate clock signal 550 and complimentary half-rate clock signal 552. Generally, phase information 530 reflects a phase relationship of input data signal 528 with respect to half-rate clock signal 550, while transition information 532 reflects that there has been a logic level change between two successive data bits of input data signal 528. As described previously, the feedback signal is adjusted to one-half the data rate of the input data signal or to another desired fractional rate of the data based on the data recovery scheme with a fixed phase relationship between the feedback signal and the input data signal.

With the high data rates prevalent in data communications (e.g., SONET), designing a 10 or greater gigabit per second oscillator is difficult using common cost effective designs. By using a one-half data rate design and sampling on both rising and falling edges of the half-rate clock signal, an effective 10 gigabit per second rate is achieved. The data contained in input data signal 528 is essentially random, thus it is just as probable to receive a consecutive series of logic ones or logic zeros as it is to receive an alternating pattern of logic ones and logic zeros. Using phase information 530 only, the phase detector will detect the consecutive series of logic ones or logic zeros as an apparent change in input data signal frequency and will change the frequency of the controlled oscillation module. Thus, phase detector 514 produces transition information 532 to indicate a change in logic levels of input data signal 528. Transition information 532 will remain at logic one as long as input data signal 528 changes logic levels at least once every one-half clock cycle, or 100 picoseconds for the 5 gigahertz feedback signal of the present design given that the loop is locked. Transition information 532 will change to a logic zero when input data signal 528 logic level remains constant, indicating same consecutive data bits. Error signal generation module 516 of Figure 12 uses the transition information to prevent controlled oscillation module 538 from erroneously changing frequency, on an average.

Input data signal 528 is coupled to a first latch 554 and a third latch 558 to produce a first latched signal 560 and a third latched signal 562, respectively. As is known by one of average skill in the art, latches couple data on an input terminal D to an output terminal Q as long as a CLK terminal on the latch is at logic one (for a positive edge latch, logic zero for negative edge latch). First latch 554 receives half-rate clock signal 550 at its CLK terminal, while third latch 558 receives complimentary half-rate signal 552 at its CLK terminal. Thus, first latch 554 triggers on the rising edge of half-rate clock signal 550, while third latch 558 effectively triggers on the falling edge of half-rate clock signal 550.

First latched signal 560 and third latched signal 562 are coupled to a second latch 566 and a fourth latch 568 to produce a second latched signal 570 and a fourth latched signal 572, respectively. Data on the input terminal D will only be coupled to the output terminal Q when the rising CLK signal crosses a voltage threshold (for a positive edge latch).

A first configuration of combinational logic 564 comprises a first exclusive OR (XOR) gate 574, a second XOR gate 578, an OR gate 582, and a third XOR gate 588. The inputs to first configuration of combinational logic 564 are coupled to the output terminals (Q terminals) of first latch 554, second latch 566, third latch 558, and fourth latch 568. Due to the quadrature sampling of half-rate clock signals (half-rate clock signal 550 and complimentary half-rate clock signal 552) and the first configuration of combinational logic 564, phase information 530 will be proportional to the phase difference between input data signal 528 and half-rate clock signal 550. The output thus reflects how far the edge of half-rate clock signal 550 (or complimentary half-rate clock signal 552) is from the center of a data bit in input data signal 528.

First XOR gate 574 is coupled to the output terminals (Q terminals) of first latch 554 and second latch 566 to produce a first combined signal 576. Second XOR gate 578 is coupled to the output terminals (Q terminals) of third latch 558 and fourth latch 568 produce a second combined signal 580. First combined signal 576 and second combined signal 580 are coupled to OR gate 582 to produce phase signed signal 583. Transition information 532 and phase signed signal 583 are coupled to the inputs of third XOR gate 588 to produce phase information 530. The width of phase information 530 will be one-half bit period (50 picoseconds for 10 gigabit per second data) when the half-rate clock signals are centered on the data bits.

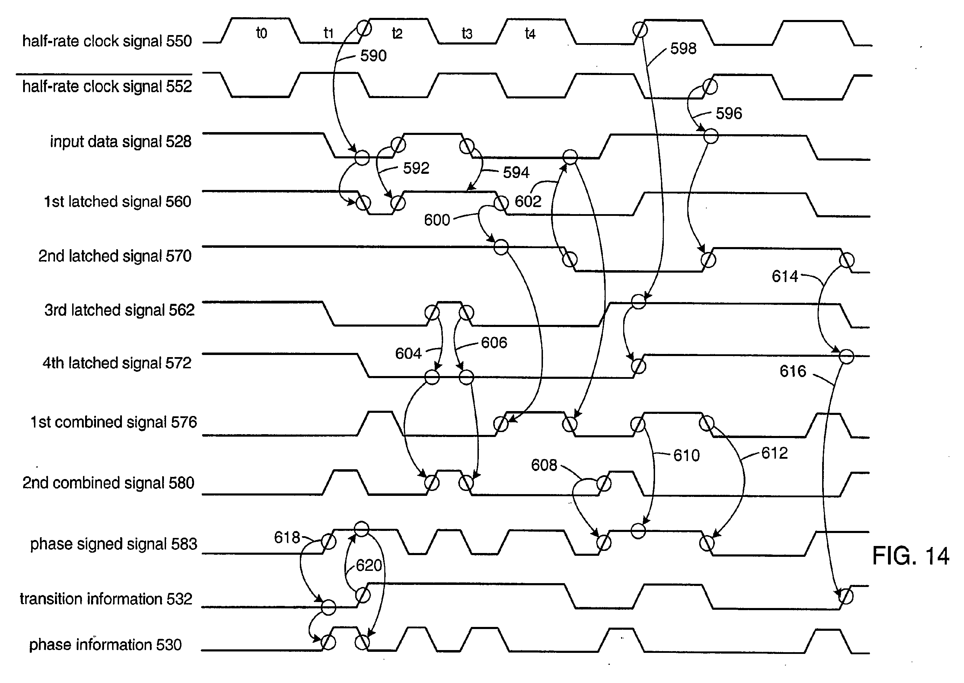

A second configuration of combinational logic 586, comprising a fourth XOR gate 584, is coupled to receive second latched signal 570 and fourth latched signal 572 and to produce transition information 532 there from. Transition information 532 is indicative of a change in input data signal 528 logic levels. The phase and transition information, as described herein, will be discussed in more detail with respect to Figure 14.

Figure 14 illustrates timing diagrams for the phase detector of Figure 13. The timing diagrams shown are for single-ended devices to simplify discussion, though one of average skill in the art should recognize that either single-ended or differential signaling may be used. Additionally, the timing diagrams illustrate signals with exaggerated rise time and fall time without overshoot or undershoot for exemplary purposes.

Referring now to Figure 14, the timing diagrams illustrate phase detector 514 (of Figure 13) locked to input data signal 528, comprising a random data bit pattern, with half-rate clock signal 550 and complimentary half-rate clock signal 552 transitioning in the center of each data bit. First latched signal 560 follows input data signal 528 during the logic one periods of half-rate clock signal 550, i.e., time periods t0, t2, t4, etc. Thus, if input data signal 528 transitions from one state to another, such as the transition during time period t2, first latched signal 560 will follow it as long as half-rate clock signal 550 is logic one. For example, at the rising edge of half-rate clock signal 550 at the start of time period t2, first latched signal 560 transitions to logic zero since input data signal 528 is logic zero. Timing line 590 indicates this sequence. When input data signal 528 transitions to logic one, first latched signal 560 also transitions to logic one as indicated by timing line 592. First latched signal 560 holds the logic one state once half-rate clock signal 550 transitions to logic zero at the end of time period t2. As shown by timing line 594, first latched signal 560 holds the logic one level when input data signal 528 transitions to logic zero.

In a similar manner, third latched signal 562 follows input data signal 528 during logic one periods of complimentary half-rate clock signal 552.

Second latched signal 570 follows first latched signal 560 during the logic one periods of complimentary half-rate clock signal 552, as shown by timing line 596. Likewise, fourth latched signal 572 follows third latched signal 562 during the logic one period of half-rate clock signal 550, as shown by timing line 598.

As was discussed previously in Figure 13, phase information 530 is produced by an exclusive OR (XOR) function of both phase signed signal 583 and transition information 530. The XOR function will produce a logic one if either input (phase signed signal 583 or transition information 530), but not both, is a logic one. For example, timing line 600 of Figure 14 shows first combined signal 576 transitioning to logic one coincident with first latched signal 560 transitioning to logic zero while second latched signal 570 is logic one. First combined signal 576 stays at logic one until second latched signal 570 transitions to logic zero, wherein first combined signal 576 transitions to logic zero, as shown by timing line 602. Second combined signal 580 is produced by the XOR function of third latched signal 562 and fourth latched signal 572, as shown by timing lines 604 and 606, respectively.

Timing lines 608 through 612 illustrate the generation of phase signed signal 583 from the OR function of first combined signal 576 or second combined signal 580. Phase signed signal 583 will be logic one if either first combined signal 576 or second combined signal 580 is at logic one.

Transition information 532 is produced from the XOR function of second latched signal 570 and fourth latched signal 572, as shown by timing lines 614 and 616, respectively. Transition information 532 will remain at logic one as long as a data transition is detected once each half-clock period. Each transition information 532 logic one transition is a multiple of one bit period.

As illustrated by timing lines 618 and 620, phase information 530 is produced by the XOR function of transition information 532 and phase signed signal 583. In operation, a pulse width of phase information 530 will be proportional to the phase difference between input data signal 528 and half-rate clock signal 550. The phase detector will adjust the phase of feedback signal 534 (not shown) to maintain the clock transitions in the center of input data signal 528 bit periods, thus, when locked, each phase information logic one pulse will be equal to one-half bit period.

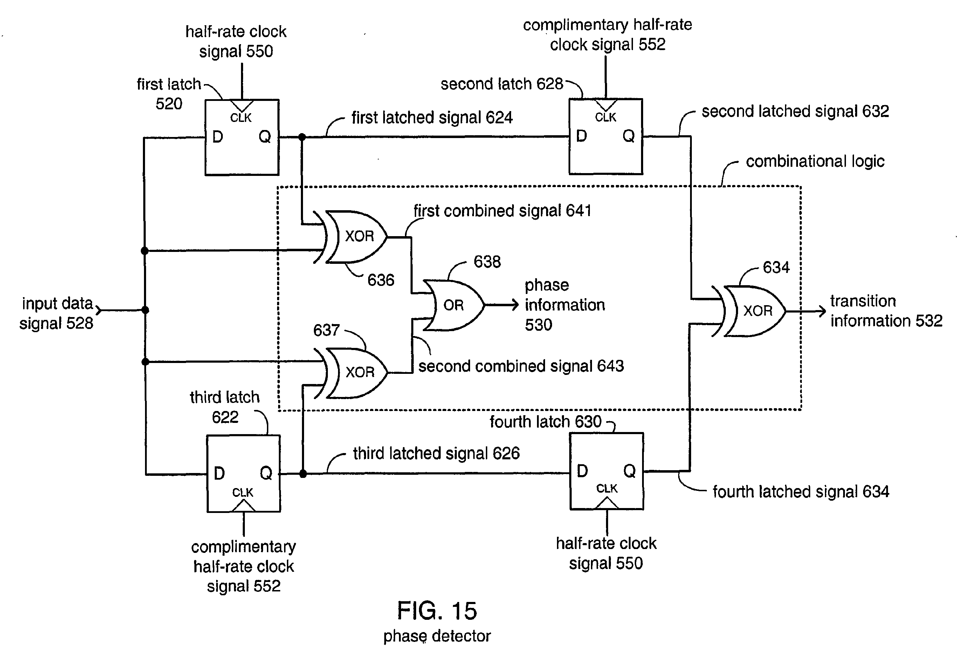

Figure 15 illustrates a schematic block diagram of an alternate embodiment of a phase detector of the phase locked loop circuit of Figure 12. The phase detector generates a one-half bit period delay between a phase signal and a transition signal. The delay is relatively timed for a middle of a first bit period and relatively timed for a beginning of a second period. Input data signal 528 is coupled to a first latch 620 and a third latch 622 to produce a first latched signal 624 and a third latched signal 626, respectively. First latch 620 receives half-rate clock signal 550 at its CLK terminal, while third latch 622 receives complimentary half-rate signal 552 at its CLK terminal. Thus, first latch 620 triggers on the rising edge of half-rate clock signal 550, while third latch 622 effectively triggers on the falling edge of half-rate clock signal 550.

First latched signal 624 and third latched signal 626 are coupled to a second latch 628 and a fourth latch 630 to produce a second latched signal 632 and a fourth latched signal 634, respectively.

The phase detector of Figure 15 further includes combinational logic that further comprises a first exclusive OR (XOR) gate 636 that is coupled to input data signal 528 and to first latched signal 624. The combinational logic further comprises a second XOR gate 637 that is coupled to input data signal 528 and to third latched signal 626. An OR gate 638 is coupled to receive the outputs of first XOR gate 636 (first combined signal 641) and second XOR gate 637 (second combined signal 643) to produce phase information 530. Phase information 530 is proportional to the phase difference between input data signal 528 and half-rate clock signal 550. The output thus reflects how far the edge of half-rate clock signal 550 (or complimentary half-rate clock signal 552) is from the center of a data bit in input data signal 528. The width of phase information 530 will be one-half bit period (50 picoseconds for 10 gigabit per second data) when the half-rate clock signals are centered on the data bits.

A_third XOR gate 634 is coupled to receive second latched signal 632 and fourth latched signal 634 and to produce transition information 532 there from. Transition information 532 is indicative of a change in input data signal 528 logic levels.

Figure 16 illustrates a schematic block diagram of coarse frequency control module 544 of Figure 12. In operation, phase locked loop circuit 510 of Figure 12 uses coarse frequency control module 544 to establish the desired frequency for controlled oscillation module 518, then phase detector 514 functions to adjust the phase of feedback signal 534 to align it with input data signal 528. In the present embodiment of the invention, a frequency of feedback signal 534 is one-half the data rate of input data signal 528. Coarse frequency control module 544 includes a crystal 640, a coarse frequency detector 642, a coarse charge pump 644, a buffer 648, and a coarse divider 650.

To establish the operating frequency for coarse frequency control module 544, crystal 640 produces a reference clock 658 that is provided to coarse frequency detector 642. Coarse frequency detector 642 determines the frequency difference between reference clock 658 and a divided representation of oscillating signal 540. Coarse divider 650 provides the divided representation of oscillating signal 540 to coarse frequency detector 642. Based on the frequency relationship of oscillating signal 540 and reference clock 658, coarse frequency detector 642 produces a coarse difference signal 660. Coarse charge pump 644 receives coarse difference signal 660 and produces a current representation thereof, namely, coarse error signal 662. Error signal generation module 516 (of Figure 12) receives coarse error signal 662 and adjusts error signal 536 accordingly. Once coarse frequency control module 544 has established an operating frequency approximately equal to a desired half-rate frequency, coarse frequency control module 544 becomes inactive, wherein phase detector 514 (of Figure 12) becomes active to adjust the phase of feedback signal 534.

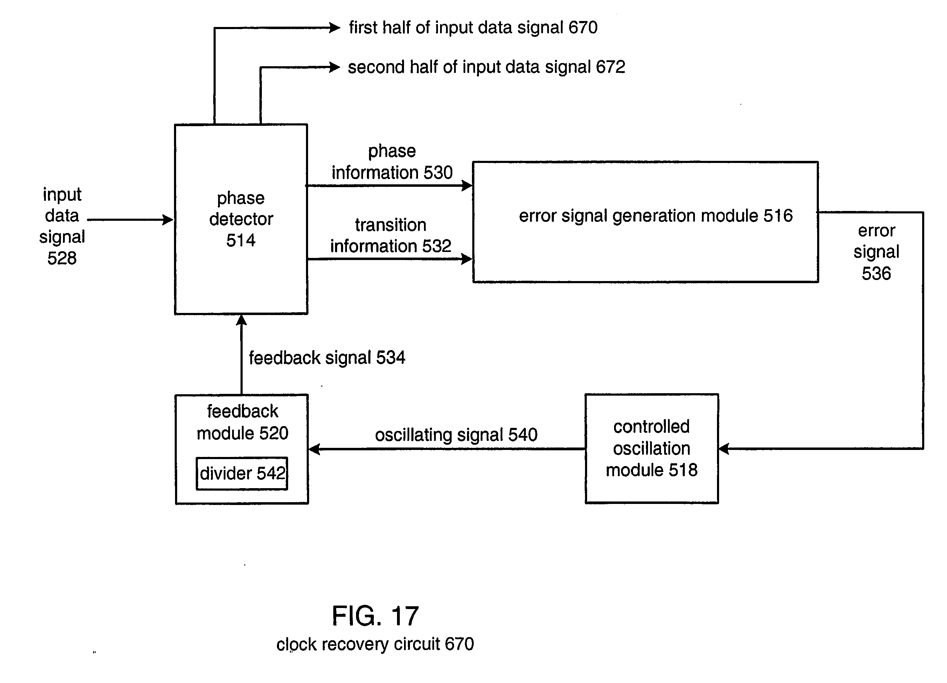

Figure 17 illustrates a block diagram of a clock recovery circuit 670 in accordance with one embodiment of the present invention. The clock recovery circuit 670 includes a phase detector 514, an error signal generation module 516, a controlled oscillation module 518, and a feedback module 520.

Phase detector 514 receives an input data signal 528, which may be a high data rate bit stream (for example, approximately 10 gigabits per second). Phase detector 514 produces phase information 530 and transition information 532 based on input data signal 528 and a feedback signal 534. Operation of phase detector 514 was discussed in Figure 13. Error signal generation module 516 produces an error signal 536 based on phase information 530 and transition information 532. Controlled oscillation module 518 receives error signal 536 and produces there from an oscillating signal 540, which represents a recovered clock signal. Feedback module 520 and a divider 542 generate feedback signal 534 by dividing oscillating signal 540 by a divider value, which may be a whole number equal to or greater than one. Feedback module 520 and divider 542 divide oscillating signal 540 to approximately one-half of the input data signal data rate. Phase detector 514 further produces second latched signal 570 and fourth latched signal 572, as was discussed with reference to Figure 13, which represent a first half of input data signal 670 and a second half of input data signal 672. Input data signal 528 can be reconstructed from first half of input data signal 670 and second half of input data signal 672 by multiplexing circuitry (not shown).

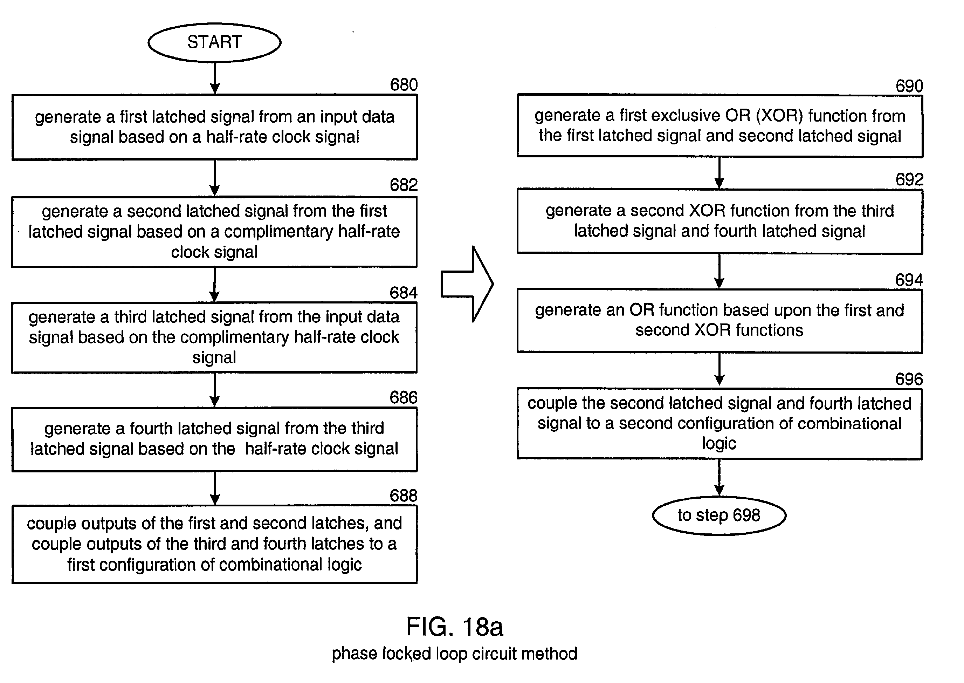

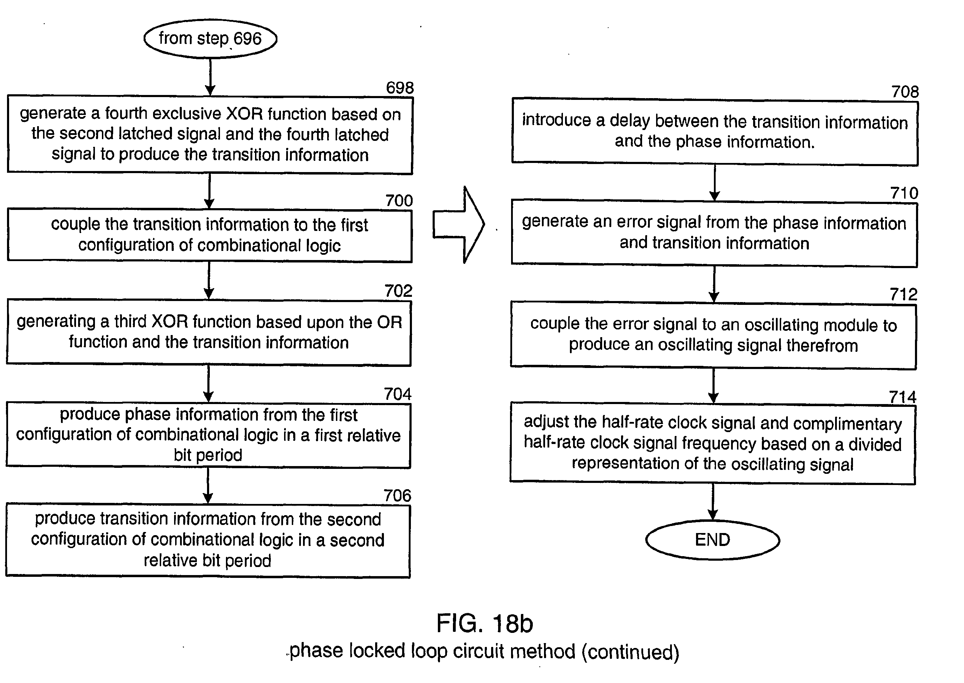

Figures 18a and 18b illustrate a flow chart of a phase locked loop method according to the present invention. An input data signal, comprising high-speed serial data, is coupled to a first latch and a third latch, wherein the first latch is clocked by a half-rate clock signal while the third latch is clocked by a complimentary half-rate clock signal. The use of a half-rate clock architecture substantially reduces the complexity of integrated circuit design. The first latch generates a first latched signal from the input data signal based on the half-rate clock (step 680). A second latch generates a second latched signal from the first latched signal based on the complimentary half-rate clock (step 682).

Based on the complimentary half-rate clock signal, the third latch generates a third latched signal from the input data signal (step 684). A fourth latch generates a fourth latched signal from the third latched signal based on the half-rate clock signal (step 686). A first configuration of combinational logic receives outputs from the first, second, third, and fourth latches (step 688). The first configuration of combinational logic comprises a first exclusive OR (XOR) gate, a second XOR gate, an OR gate, and a third XOR gate. The first XOR function, coupled to receive the first latched signal and the second latched signal (step 690), generates a logic one if either input, but not both, is a logic one. The second XOR gate, coupled to receive the third latched signal and to receive the fourth latched signal, generates a second XOR function (step 692). The first and second XOR functions are coupled to the OR gate for generating the OR function (step 694).

The second latched signal and fourth latched signal are coupled out of the second and fourth latches, respectively, to a second configuration of combinational logic (step 696). The second configuration of combinational logic comprises a fourth XOR gate coupled to receive the second latched signal and coupled to receive the fourth latched signal to produce the transition information there from (step 698). The transition information is coupled to the first configuration of combinational logic (step 700).

The output of the OR function and the transition information are coupled to generate a third XOR function (step 702). Coupled out of the first configuration of combinational logic, the aforementioned functions produce the phase information in a first relative bit period (step 704). The coupling of the first configuration of combinational logic and the second configuration of combinational logic across the first, second, third, and fourth latches introduces a delay of one data period between the phase information and the transition information in one embodiment. Generally though, the transition information is produced in the second bit period relative (step 706) to the first bit period in which the phase information is introduced. The timing between the first relative bit period and the second relative bit period functions to introduce a delay between the transition information and the phase information (step 708). The delay is relatively timed from a middle of the first bit period to the beginning of the second bit period. Based on the design architecture, the delay is approximately equal to one-half bit period to one and one-half bit periods. Thus the delay is approximately a multiple of one-half bit periods. The phase information and transition information are used to generate an error signal there from (step 710). The error signal is coupled to an oscillating module (step 712) from which an oscillating signal is produced. The oscillating signal is coupled to a feedback module and a divider that produces a divided representation of the oscillating signal. The phase detector receives the divide representation of the oscillating and adjusts the half-rate and complimentary half-rate clock signal accordingly (step 714).

The invention disclosed herein is susceptible to various modifications and alternative forms. Specific embodiments therefore have been shown by way of example in the drawings and detailed description. It should be understood, however, that the drawings and detailed description thereto are not intended to limit the invention to the particular form disclosed, but on the contrary, the invention is to cover all modifications, equivalents and alternatives falling within the scope of the present invention as defined by the claims.

## Claims

1. A circuit comprises:
phase detector (14) operably coupled to produce a phase information signal and a transition information signal based on a feedback signal (28) and an input data signal (22);
an error signal generation module (16) operably coupled to generate an error signal (30) based on the phase information signal and the transition information signal;
controlled oscillation module (18) operably coupled to convert the error signal into an oscillating signal; and
feedback module (20) operably coupled to generate the feedback signal based on the oscillating signal and a divider value;
wherein the error signal generation module:
generates a first signal component when the phase information signal is in a first state;
generates a second signal component when the phase information signal is in a second state;
generates a third signal component when the transition information signal is in a first state;
generates a fourth signal component when the transition information signal is in a second state; and
generates the error signal based on the first, second, third, and fourth signal components;
wherein the phase detector further comprises:
a first latch (554) operably coupled to latch the input data signal (528) based on a half-rate clock signal (550) to produce a first latched signal (560);
a second latch (566) operably coupled to latch the first latched signal based on a complimentary half-rate clock signal (552) to produce a second latched signal (570);
a third latch (558) operably coupled to latch the input data signal based on the complimentary half-rate clock signal (552) to produce a third latched signal (562);
a fourth latch (568) operably coupled to latch the third latched signal based on the half-rate clock signal (550) to produce a fourth latched signal (572); and
combinational logic circuitry (564,586) operably coupled to the first, second, third, and fourth latches to produce the phase information and the transition information signals, wherein the phase information signal is reliably timed to a middle of the first bit period and the transition information signal is reliably timed for a beginning of the second bit period; and
wherein the combination logic circuitry comprises:
a first configuration of combinational logic (564) operably coupled to outputs of the first latch, second latch, third latch, fourth latch, and to an output of a second configuration of combinational logic to produce the phase information signal; and
said second configuration of combinational logic (586) is operably coupled to outputs of the second and fourth latches to produce the transition information signal.

2. The circuit of claim 1, wherein the error signal generation module further comprises:
superposition circuitry (32), operably coupled to receive the phase information and transition information signals generated with an offset relative to each other wherein the superposition circuitry generates the first, second, third, and fourth signal components as current components therefrom to provide accurate frequency and phase correction on average rather than instantaneously and further wherein a delay in one or both of the phase and transition information signals does not adversely affect the accuracy of the frequency and phase correction on average rendering the superposition circuitry delay insensitive; and
an output module (34) operably coupled to generate the error signal from the current components and further coupled to shift common mode of the error signal, wherein the output module has a bandwidth greater than a data rate.

3. The circuit of claim 2, wherein the superposition circuitry sinks current as the first signal component from the output module when the phase information signal is a logic zero, wherein the superposition circuitry sources current as the second signal component to the output module when the phase information signal is a logic one,
wherein the superposition circuitry sources current as the third signal component to the output module when the transition information signal is a logic zero, and wherein the superposition circuitry provides zero current as the fourth signal component when the transition information signal is a logic one.

4. The circuit of any one of the preceding claims, wherein the phase detector further comprises:
a first latch (40) operably coupled to latch the input data signal based on the feedback signal to produce a first latched signal (44);
a first master/slave flip-flop (50) operably coupled to latch the first latched signal (54) based on a complimentary feedback signal to produce an odd data output signal;
a second latch (42) operably coupled to latch the input data signal based on the complimentary feedback signal to produce a second latched signal (46);
a second master/slave flip-flop (52) operably coupled to latch the second latched signal based on the feedback signal to produce an even data output signal (56); and
logic (58) operably coupled to the first latch, second latch, first master/slave flip-flop, and second master/slave flip-flop to produce the phase information and the transition information signals.

5. The circuit of any one of the preceding claims, wherein the phase information is produced by combinational logic coupled across the second and fourth latches and coupled to the transition information signal.

6. The circuit of any of claims 1 to 4, wherein the first configuration of combinational logic:
couples the first latched signal and the second latched signal to a first exclusive OR gate(XOR)(574)to produce a first combined signal (576);
couples the third latched signal and the fourth latched signal to a second XOR (578) gate to produce a second combined signal (580);
couples the first combined signal and the second combined signal to an OR gate (582) to produce a phase signed signal (583); and
couples the phase signed signal and the transition information to a third XOR (588) gate to produce the phase information signal (530); and
wherein the second configuration of combinational logic couples the second latched signal and the fourth latched signal to a fourth XOR (584) gate to produce the transition information signal (532).

7. The circuit of claim 1, wherein the phase information signal is produced by combinational logic coupled to the input data signal and to outputs of the first and third latches.

8. The circuit of claim 7, wherein a configuration of combinational logic:
couples the input data signal and the first latched signal to a first exclusive OR gate (XOR) to produce a first combined signal;
couples the input data signal and the third latched signal to a second XOR gate to produce a second combined signal; and
couples the first combined signal and the second combined signal to an OR gate to produce the phase information signal; and
wherein the configuration of combinational logic further couples the second latched signal and the fourth latched signal to a third XOR gate to produce the transition information signal.

9. The circuit of any one of the preceding claims, wherein the error signal generation module comprises:
a plurality of current sources for generating a first amount of current;
a first current sink for sinking for sinking a second amount of current;
a second current sink for sinking a third amount of current;
selectable switch circuitry coupled between the plurality of current sources and first and second current sinks to control how much current from the plurality of current sources is produced to the first and second current sinks; and
an output module coupled between the plurality of current sources and the first and second current sinks for sourcing and sinking current responsive to the selectable switch circuitry.

10. The circuit of any one of the preceding claims, wherein a delay is introduced between the phase information and the transition information signals, wherein the delay is preferably relatively timed from a middle of a first bit period to a beginning of a second bit period.

11. The circuit of any one of the preceding claims, wherein the controlled oscillation module further comprises a coarse frequency control module (544) coupled to lock the controlled oscillation module to an oscillating frequency substantially equal to one-half the input data signal.

12. The circuit of any one of the preceding claims further comprises an analog front end (AFE) operably coupled to receive a serial data stream and to produce therefrom the input data signal.

## Patentansprüche

1. Schaltkreis, umfassend:
einen Phasendetektor (14), betriebsfähig gekoppelt zum Erzeugen eines Phaseninformationssignals und eines Transitionsinformationssignals auf der Basis eines Feedbacksignals (28) und eines Eingangssignals (22);
ein Fehlersignal-Erzeugungsmodul (16), betriebsfähig gekoppelt zum Erzeugen eines Fehlersignals (30) auf der Basis des Phaseninformationssignals und des Transitionsinformationssignals;
ein gesteuertes Schwingungsmodul (18), betriebsfähig gekoppelt zum Umwandeln des Fehlersignals in ein Schwingungssignal; und
ein Feedbackmodul (20), betriebsfähig gekoppelt zum Erzeugen des Feedbacksignals auf der Basis des Schwingungssignals und eines Dividiererwerts;
worin das Fehlersignal-Erzeugungsmodul:
eine erste Signalkomponente erzeugt, wenn das Phaseninformationssignal in einem ersten Zustand ist;
eine zweite Signalkomponente erzeugt, wenn das Phaseninformationssignal in einem zweiten Zustand ist;
eine dritte Signalkomponente erzeugt, wenn das Transitionsinformationssignal in einem ersten Zustand ist;
eine vierte Signalkomponente erzeugt, wenn das Transitionsinformationssignal in einem zweiten Zustand ist; und
das auf den ersten, zweiten, dritten und vierten Signalkomponenten basierende Fehlersignal erzeugt;
worin der Phasendetektor außerdem umfasst:
einen ersten Latch (554), betriebsfähig gekoppelt zum Latchen des Eingangsdatensignals (528) auf der Basis eines Halbraten-Taktsignals (550), um ein erstes gelatchtes Signal (560) zu erzeugen;
einen zweiten Latch (566), betriebsfähig gekoppelt zum Latchen des ersten gelatchten Signals auf der Basis eines komplementären Halbraten-Taktsignals (552), um ein zweites gelatchtes Signal (570) zu erzeugen;
einen dritten Latch (558), betriebsfähig gekoppelt zum Latchen des Eingangsdatensignals auf der Basis des komplementären Halbraten-Taktsignals (552), um ein drittes gelatchtes Signal (562) zu erzeugen;
einen vierten Latch (568), betriebsfähig gekoppelt zum Latchen des dritten gelatchten Signals auf der Basis des Halbraten-Taktsignals (550), um ein viertes gelatchtes Signal (572) zu erzeugen; und
eine kombinatorische Logikschaltungsanordnung (564, 586), betriebfähig an die ersten, zweiten, dritten und vierten Latches gekoppelt, um die Phaseninformations- und Transitionsinformationssignale zu erzeugen, worin das Phaseninformationssignal zuverlässig auf eine Mitte der ersten Bitperiode getimt ist und das Transitionsinformationssignal zuverlässig auf einen Anfang der zweiten Bitperiode getimt ist; und
worin die kombinatorische Logikschaltungsanordnung umfasst:
eine erste kombinatorische Logikkonfiguration (564), betriebsfähig gekoppelt an Ausgänge des ersten Latches, des zweiten Latches, des dritten Latches, des vierten Latches und an einen Ausgang einer zweiten kombinatorischen Logikkonfiguration, um das Phaseninformationssignal zu erzeugen; und
wobei die zweite kombinatorische Logikkonfiguration (586) betriebsfähig gekoppelt ist an Ausgänge des zweiten und vierten Latches, um das Transitionssinformationssignal zu erzeugen.

2. Schaltung nach Anspruch 1, worin das Fehlersignal-Erzeugungsmodul außerdem umfasst:
eine Superpositionsschaltungsanordnung (32), betriebsfähig gekoppelt zum Empfangen der Phaseninformations- und Transitionsinformationssignale, die gegeneinander versetzt erzeugt werden, worin die Superpositionsschaltungsanordnung daraus die ersten, zweiten, dritten und vierten Signalkomponenten als Stromkomponenten erzeugt, um genaue Frequenz- und Phasenkorrektur nicht sofort, sondern im Mittel bereitzustellen, und worin außerdem eine Verzögerung in einem oder beiden der Phasen- und Transitionsinformationssignale die Genauigkeit der Frequenz- und Phasenkorrektur nicht nachteilig beeinflusst, was die Superpositionsschaltungsanordnung im Mittel verzögerungsunempfindlich macht; und
ein Ausgangsmodul (34), betriebsfähig gekoppelt zum Erzeugen des Fehlersignals aus den Stromkomponenten und außerdem gekoppelt zum Verschieben des Gleichtakts des Fehlersignals, worin das Ausgangsmodul eine Bandbreite hat, die größer als eine Datenrate ist.

3. Schaltung nach Anspruch 2, worin die Superpositionsschaltungsanordnung Strom als die erste Signalkomponente vom Ausgangsmodul verbraucht, wenn das Phaseninfortnationssignal eine logische Null ist, worin die Superpositionsschaltungsanordnung Strom als die zweite Signalkomponente an das Ausgangsmodul liefert, wenn das Phaseninformationssignal eine logische Eins ist, worin die Superpositionsschaltungsanordnung Strom als die dritte Signalkomponente an das Ausgangsmodul liefert, wenn das Transitionsinfonnationssignal eine logische Null ist, und worin die Superpositionsschaltungsanordnung Nullstrom als die vierte Signalkomponente bereitstellt, wenn das Transifionsinformationssignal eine logische Eins ist.

4. Schaltung nach einem der vorhergehenden Ansprüche, worin der Phasendetektor außerdem umfasst:
einen ersten Latch (40), betriebsfähig gekoppelt zum Latchen des Eingangsdatensignals auf der Basis des Feedbacksignals, um ein erstes gelatchtes Signal (44) zu erzeugen;
ein erstes Master-Slave-Flipflop (50), betriebsfähig gekoppelt zum Latchen des ersten gelatchten Signals (54) auf der Basis eines komplementären Feedbacksignals, um ein ungerades Datenausgangssignal zu erzeugen;
einen zweiten Latch (42), betriebsfähig gekoppelt zum Latchen des Eingangsdatensignals auf der Basis des komplementären Feedbacksignals, um ein zweites gelatchtes Signal (46) zu erzeugen;
ein zweites Master-Slave-Flipflop (52), betriebsfähig gekoppelt zum Latchen des zweiten gelatchten Signals auf der Basis des Feedbacksignals, um ein gerades Datenausgangssignal (56) zu erzeugen; und
eine Logik (58), betriebsfähig an den ersten Latch, den zweiten Latch, das erste Master-Slave-Flipflop und das zweite Master-Slave-Flipflop gekoppelt, um die Phaseninformations- und die Transitionsinformationssignale zu erzeugen.

5. Schaltung nach einem der vorhergehenden Ansprüche, worin die Phaseninformation durch kombinatorische Logik erzeugt wird, gekoppelt über die zweiten und vierten Latches und an das Transitionsinformationssignal.

6. Schaltung nach einem der Ansprüche 1 bis 4, worin die erste kombinatorische Logikkonfiguration:
das erste gelatchte Signal und das zweite gelatchte Signal an ein erstes Exklusiv-OR-Gatter (XOR) (574) koppelt, um ein erstes kombiniertes Signal (576) zu erzeugen;
das dritte gelatchte Signal und das vierte gelatchte Signal an ein zweites XOR-Gatter(578) koppelt, um ein zweites kombiniertes Signal (580) zu erzeugen;
das erste kombinierte Signal und das zweite kombinierte Signal an ein OR-Gatter (582) koppelt, um ein Phasenvorzeichensignal (583) zu erzeugen; und
das Phasenvorzeichensignal und die Transitionsinformation an ein drittes XOR-Gatter (588) koppelt, um das Phaseninformationssignal (530) zu erzeugen; und
worin die zweite kombinatorische Logikkonfiguration das zweite gelatchte Signal und das vierte gelatchte Signal an ein viertes XOR-Gatter (584) koppelt, um das Transitionsinformationssignal (532) zu erzeugen.

7. Schaltung nach Anspruch 1, worin das Phaseninfortnationssignal durch kombinatorische Logik erzeugt wird, gekoppelt an das Eingangsdatensignal und an Ausgänge des ersten und dritten Latches.

8. Schaltung nach Anspruch 7, worin eine kombinatorische Logikkonfiguration:
das Eingangsdatensignal und das erste gelatchte Signal an ein erstes Eidclusiv-OR-Gatter (XOR) koppelt, um ein erstes kombiniertes Signal zu erzeugen;
das Eingangsdatensignal und das dritte gelatchte Signal an ein zweites XOR-Gatter koppelt, um ein zweites kombiniertes Signal zu erzeugen; und
das erste kombinierte Signal und das zweite kombinierte Signal an ein OR-Gatter koppelt, um das Phaseninformationssignal zu erzeugen; und
worin die kombinatorische Logikkonfiguration außerdem das zweite gelatchte Signal und das vierte gelatchte Signal an ein drittes XOR-Gatter koppelt, um das Transitionsinformationssignal zu erzeugen.

9. Schaltung nach einem der vorhergehenden Ansprüche, worin das Fehlersignal-Erzeugungsmodul umfasst:
eine Vielzahl von Stromquellen zum Erzeugen einer ersten Strommenge;
eine erste Stromsenke zum Verbrauchen einer zweiten Strommenge;
eine zweite Stromsenke zum Verbrauchen einer dritten Strommenge;
eine auswählbare Schaltungsanordnung, zwischen die Vielzahl der Stromquellen und die ersten und zweiten Stromsenken gekoppelt, um zu steuern, wie viel Strom von der Vielzahl der Stromquellen an die ersten und zweiten Stromsenken erzeugt wird; und
ein Ausgangsmodul, zwischen die Vielzahl der Stromquellen und die erste und zweite Stromsenke gekoppelt zum Liefern und Verbrauchen von Strom mit Ansprechempfindlichkeit für die auswählbare Schaltungsanordnung.

10. Schaltung nach einem der vorhergehenden Ansprüche, worin zwischen die Phasen- und Transitionsinformationssignale eine Verzögerung eingeführt wird, worin die Verzögerung vorzugsweise von einer Mitte einer ersten Bitperiode zu einem Anfang einer zweiten Bitperiode relativ getimt wird.

11. Schaltung nach einem der vorhergehenden Ansprüche, worin das gesteuerte Schwingungsmodul außerdem ein Grobfrequenz-Steuerungsmodul (544) umfasst, gekoppelt zum Anschließen des gesteuerten Schwingungsmoduls an eine Schwingungsfrequenz, die im Wesentlichen gleich dem halben Eingangsdatensignal ist.

12. Schaltung nach einem der vorhergehenden Ansprüche, die außerdem ein Analog-Frontend (AFE) umfasst, betriebsfähig gekoppelt, um einen seriellen Datenstrom zu empfangen und daraus das Eingangsdatensignal zu erzeugen.

## Revendications

1. Circuit comprenant :
un détecteur de phase (14) couplé de manière fonctionnelle pour produire un signal d'informations de phase et un signal d'informations de transition sur la base d'un signal de rétroaction (28) et d'un signal de données d'entrée (22) ;
un module de génération de signal d'erreur (16) couplé de manière fonctionnelle pour générer un signal d'erreur (30) sur la base du signal d'informations de phase et du signal d'informations de transition ;
un module à oscillation contrôlée (18) couplé de manière fonctionnelle pour convertir le signal d'erreur en un signal d'oscillation ; et
un module de rétroaction (20) couplé de manière fonctionnelle pour générer le signal de rétroaction sur la base du signal d'oscillation et d'une valeur de diviseur ;
dans lequel le module de génération de signal d'erreur :
génère une première composante de signal lorsque le signal d'informations de phase est dans un premier état ;
génère une deuxième composante de signal lorsque le signal d'informations de phase est dans un deuxième état ;
génère une troisième composante de signal lorsque le signal d'informations de transition est dans un premier état ;
génère une quatrième composante de signal lorsque le signal d'informations de transition est dans un deuxième état ; et
génère le signal d'erreur sur la base des première, deuxième, troisième et quatrième composantes de signal ;
dans lequel le détecteur de phase comprend en outre :
une première bascule (554) couplée de manière fonctionnelle pour verrouiller le signal de données d'entrée (528) sur la base d'un signal d'horloge à mi-fréquence (550) pour produire un premier signal verrouillé (560) ;
une deuxième bascule (566) couplée de manière fonctionnelle pour verrouiller le premier signal verrouillé sur la base d'un signal d'horloge à mi-fréquence complémentaire (552) pour produire un deuxième signal verrouillé (570) ;
une troisième bascule (558) couplée de manière fonctionnelle pour verrouiller le signal de données d'entrée sur la base du signal d'horloge à mi-fréquence complémentaire (552) pour produire un troisième signal verrouillé (562) ;
une quatrième bascule (568) couplée de manière fonctionnelle pour verrouiller le troisième signal verrouillé sur la base du signal d'horloge à mi-fréquence (550) pour produire un quatrième signal verrouillé (572); et
des éléments de circuit de logique combinatoire (564, 586) couplés de manière fonctionnelle aux première, deuxième, troisième et quatrième bascules pour produire les signaux d'informations de phase et d'informations de transition, dans lequel le signal d'informations de phase est synchronisé de manière fiable à une moitié de la première période de bit et le signal d'informations de transition est synchronisé de manière fiable pour un début de la deuxième période de bit ; et
dans lequel les éléments de circuit de logique combinatoire comprennent :
une première configuration de logique combinatoire (564) couplée de manière fonctionnelle aux sorties de la première bascule, de la deuxième bascule, de la troisième bascule, de la quatrième bascule, et à une sortie d'une deuxième configuration de logique combinatoire pour produire le signal d'informations de phase ; et
ladite deuxième configuration de logique combinatoire (586) est couplée de manière fonctionnelle aux sorties des deuxième et quatrième bascules pour produire le signal d'informations de transition.

2. Circuit selon la revendication 1, dans lequel le module de génération de signal d'erreur comprend en outre :
des éléments de circuit de superposition (32), couplés de manière fonctionnelle pour recevoir les signaux d'informations de phase et d'informations de transition générés avec un décalage l'un par rapport à l'autre, dans lequel les éléments de circuit de superposition génèrent les première, deuxième, troisième et quatrième composantes de signal en tant que composantes de courant à partir de ceux-ci pour réaliser une correction de fréquence et de phase précise en moyenne plutôt qu'instantanément, et dans lequel en outre un retard dans l'un des signaux d'informations de phase et de transition, ou dans les deux, n'affecte pas de manière négative la précision de la correction de fréquence et de phase en moyenne, rendant les éléments de circuit de superposition insensibles au retard ; et
un module de sortie (34) couplé de manière fonctionnelle pour générer le signal d'erreur à partir des composantes de courant et couplé en outre pour changer le mode commun du signal d'erreur, dans lequel le module de sortie a une bande passante supérieure à un débit de données.

3. Circuit selon la revendication 2, dans lequel les éléments de circuit de superposition collectent le courant en tant que première composante de signal provenant du module de sortie lorsque le signal d'informations de phase est un zéro logique, dans lequel les éléments de circuit de superposition délivrent le courant en tant que deuxième composante de signal au module de sortie lorsque le signal d'informations de phase est un un logique, dans lequel les éléments de circuit de superposition délivrent le courant en tant que troisième composante de signal au module de sortie lorsque le signal d'informations de transition est un zéro logique, et dans lequel les éléments de circuit de superposition fournissent un courant nul en tant que quatrième composante de signal lorsque le signal d'informations de transition est un un logique.

4. Circuit selon l'une quelconque des revendications précédentes, dans lequel le détecteur de phase comprend en outre :
une première bascule (40) couplée de manière fonctionnelle pour verrouiller le signal de données d'entrée sur la base du signal de rétroaction pour produire un premier signal verrouillé (44) ;
une première bascule bistable maître/esclave (50) couplée de manière fonctionnelle pour verrouiller le premier signal verrouillé (54) sur la base d'un signal de rétroaction complémentaire pour produire un signal de sortie de données impaire ;
une deuxième bascule (42) couplée de manière fonctionnelle pour verrouiller le signal de données d'entrée sur la base du signal de rétroaction complémentaire pour produire un deuxième signal verrouillé (46);
une deuxième bascule bistable maître/esclave (52) couplée de manière fonctionnelle pour verrouiller le deuxième signal verrouillé sur la base du signal de rétroaction pour produire un signal de sortie de données paire (56) ; et
une logique (58) couplée de manière fonctionnelle à la première bascule, à la deuxième bascule, à la première bascule bistable maître/esclave et à la deuxième bascule bistable maître/esclave pour produire les signaux d'informations de phase et d'informations de transition.

5. Circuit selon l'une quelconque des revendications précédentes, dans lequel les informations de phase sont produites par une logique combinatoire couplée entre les deuxième et quatrième bascules et couplée au signal d'informations de transition.

6. Circuit selon l'une quelconque des revendications 1 à 4, dans lequel la première configuration de logique combinatoire :
couple le premier signal verrouillé et le deuxième signal verrouillé à une première porte OU exclusif (XOR) (574) pour produire un premier signal combiné (576) ;
couple le troisième signal verrouillé et le quatrième signal verrouillé à une deuxième porte OU exclusif (578) pour produire un deuxième signal combiné (580) ;
couple le premier signal combiné et le deuxième signal combiné à une porte OU (582) pour produire un signal de phase signé (583) ; et
couple le signal de phase signé et les informations de transition à une troisième porte OU exclusif (588) pour produire le signal d'informations de phase (530) ; et
dans lequel la deuxième configuration de logique combinatoire couple le deuxième signal verrouillé et le quatrième signal verrouillé à une quatrième porte OU exclusif (584) pour produire le signal d'informations de transition (532).

7. Circuit selon la revendication 1, dans lequel le signal d'informations de phase est produit par une logique combinatoire couplée au signal de données d'entrée et aux sorties des première et troisième bascules.

8. Circuit selon la revendication 7, dans lequel une configuration de logique combinatoire :
couple le signal de données d'entrée et le premier signal verrouillé à une première porte OU exclusif (XOR) pour produire un premier signal combiné ;
couple le signal de données d'entrée et le troisième signal verrouillé à une deuxième porte OU exclusif pour produire un deuxième signal combiné ; et
couple le premier signal combiné et le deuxième signal combiné à une porte OU pour produire le signal d'informations de phase ; et
dans lequel la configuration de logique combinatoire couple en outre le deuxième signal verrouillé et le quatrième signal verrouillé à une troisième porte OU exclusif pour produire le signal d'informations de transition.

9. Circuit selon l'une quelconque des revendications précédentes, dans lequel le module de génération de signal d'erreur comprend :
une pluralité de sources de courant pour générer une première quantité de courant ;
un premier puits de courant pour collecter une deuxième quantité de courant ;
un deuxième puits de courant pour collecter une troisième quantité de courant ;
des éléments de circuit de commutation sélectionnables couplés entre la pluralité de sources de courant et les premier et deuxième collecteurs de courant pour contrôler la quantité de courant produite par la pluralité de sources de courant vers les premier et deuxième puits de courant ; et
un module de sortie couplé entre la pluralité de sources de courant et les premier et deuxième collecteurs de courant pour délivrer et collecter un courant en réponse aux éléments de circuit de commutation sélectionnables.

10. Circuit selon l'une quelconque des revendications précédentes, dans lequel un retard est introduit entre les signaux d'informations de phase et d'informations de transition, dans lequel le retard est de préférence relativement synchronisé du milieu d'une première période de bit à un début d'une deuxième période de bit.

11. Circuit selon l'une quelconque des revendications précédentes, dans lequel le module à oscillation contrôlée comprend en outre un module de commande de fréquence grossière (544) couplé pour verrouiller le module à oscillation contrôlée à une fréquence d'oscillation sensiblement égale à une moitié du signal de données d'entrée.

12. Circuit selon l'une quelconque des revendications précédentes, comprenant en outre une extrémité avant analogique (AFE) couplée de manière fonctionnelle pour recevoir un flot de données série et pour produire à partir de celui-ci le signal de données d'entrée.
